# EUROPÄISCHE PATENTSCHRIFT

(11) **EP 3 472 913 B1**
(45) Veröffentlichungstag und Bekanntmachung des Hinweises auf die Patenterteilung: **27.05.2020**
(21) Anmeldenummer: 17737489.9
(22) Anmeldetag: 15.06.2017
(51) Int. Cl.: H02J 3/38, H02J 3/40, H02J 7/00, H02J 7/34, H02J 1/10, H02J 1/00, H04B 3/54, G01R 31/36, H01M 10/42

(54) **ELEKTRISCHE ENERGIEVERSORGUNGSEINHEIT UND STEUERUNG DAFÜR**
ELECTRICAL ENERGY SUPPLY UNIT AND CONTROL THEREFOR
UNITÉ D'ALIMENTATION EN ÉNERGIE ÉLECTRIQUE ET COMMANDE AFFÉRENTE

(30) Priorität: 15.06.2016 WO PCT/EP2016/063787
(43) Veröffentlichungstag der Anmeldung: 24.04.2019
(73) Patentinhaber: Power-Blox AG, 5070 Frick (CH)
(72) Erfinder: MEDICI, Alessandro, 5080 Laufenburg (CH)
(74) Vertreter: Keller & Partner Patentanwälte AG
(86) Internationale Anmeldenummer: PCT/EP2017/064705
(87) Internationale Veröffentlichungsnummer: WO 2017/216308

(56) Entgegenhaltungen:
- EP-A1- 2 408 083
- EP-A1- 2 595 218
- EP-A1- 2 830 183
- EP-A1- 2 858 200

## Beschreibung

### Technisches Gebiet

Die Erfindung betrifft eine Steuerung für eine elektrische Energieversorgungseinheit sowie eine elektrische Energieversorgungseinheit. Ferner bezieht sich die Erfindung auf ein elektrisches Energieversorgungssystem und ein Verfahren zum Steuern einer elektrischen Energieversorgungseinheit.

### Stand der Technik

Mehr als eine Milliarde Menschen leben ohne Zugang zu elektrischer Energie. Auch auf absehbare Zeit werden 70% davon keinen Zugang zu einem öffentlichen elektrischen Versorgungsnetz (Makro-Grid) erlangen. Einerseits behindert dies die ökonomische Entwicklung der betroffenen Menschen sowie deren Bildung und Gesundheit. Andererseits entsteht ein zunehmender Bedarf nach Versorgung mit elektrischer Energie, die unabhängig von einem öffentlichen elektrischen Versorgungsnetz zur Verfügung steht.

Der heutige Markt bietet eine Vielzahl von Lösungen dafür. Beispielsweise gibt es Dieselgeneratoren, die allerdings teuer im Betrieb sind und auf Grund oftmals fehlenden Unterhalts als unzuverlässig gelten. Des Weiteren sind Kleinst-Solaranlagen bekannt, die für den privaten Bereich geeignet sind, aber einen kleinen Leistungsbereich und eine kurze Lebensdauer haben sowie nicht für Erweiterungen vorgesehen sind. Am Markt verfügbar sind auch Inselsysteme (Mikro-Grids), die anwendungsspezifisch ausgelegt werden. Nachteilhaft sind hierbei die hohen Anschaffungskosten des gesamten Inselsystems sowie die in der Regel nur von einem Fachmann ausführbare Installation. Ferner sind solche Inselsysteme wenig flexibel und nur beschränkt erweiterbar. Neue und alte Inselsysteme sind oft nicht miteinander kombinierbar oder nur mit beträchtlichem Aufwand. Inselsysteme verfügen in der Regel über eine zentrale Steuerung, die bei Erweiterung neu programmiert oder angepasst werden muss. Der Ausfall einer einzigen kritischen Komponente kann das gesamte System unbrauchbar machen. Oft ist auch nicht gewährleistet, dass die Batterien, die in einem Inselsystem verwendet werden, alle den gleichen Ladezustand haben. Ein derartiges Inselsystem, welches einige der oben genannten Nachteile überwindet, ist aus der EP 2 827 467 A2 bekannt, in der eine Vorrichtung und ein Verfahren zur stabilen Erzeugung elektrischer Energie gezeigt werden.

EP 2 858 200 A1 (Osaka Gas Co.) offenbart ein Stromversorgungssystem, das eine hohe Energiereserve ermöglicht. Das System umfasst eine Vielzahl von lokalen Systemen, die ihrerseits jeweils einen Wechselspannungsanschluss, einen Energiespeicher, einen lokalen Umrichter und eine Vielzahl von Verbrauchern aufweisen. Zwischen den lokalen Systemen befinden sich Verbindungsumrichter, sodass die lokalen Systeme elektrisch in Serie geschaltet sind. Wenn das lokale System nicht mit dem Netz verbunden ist, steuert ein Steuergerät den lokalen Umrichter so, dass die Frequenz des Wechselspannungsnetzes abhängig vom Ladezustand des Energiespeichers ist. Das Steuergerät steuert einen Energieaustausch zwischen den lokalen Systemen, so dass der Verbindungsumrichter elektrische Energie von dem lokalen System mit dem relativ höheren Ladezustand zu dem lokalen System mit dem relativ niedrigeren Ladezustand überträgt, basierend auf den ladezustandsabhängigen Netzfrequenzen.

EP 2 830 183 A1 (Osaka Gas Co.) offenbart eine Vorrichtung und ein System zur Steuerung eines Energieverbrauchsmodus, wobei ein linearer Zusammenhang zwischen dem Ladezustand eines Energiespeichers und der Frequenz des Wechselspannungsnetzes vorgeschlagen wird. Die Vorrichtung zum Steuern des Energieverbrauchsmodus weist unter anderem eine Frequenz-Detektiereinheit auf.

EP 2 595 218 A1 (Samsung SDI Co., Robert Bosch GmbH) offenbart ein Verfahren zum überwachen einer Batterie. Grössen wie beispielsweise die Zelltemperaturen einer vielseitigen Batterie eines Hybrid- oder Elektrofahrzeuges sollen ohne individuelle Verkabelung gemessen werden. Jede Zelle enthält eine elektronische Einheit zur Aufnahme einer Messgrösse, die trägerfrequent übertragen werden kann.

EP 2 408 083 A1 (Vpec Inc) offenbart ein autonomes verteiltes Wechselspannungssystem. Jeder Stromversorger und Stromverbraucher des Systems weist zumindest ein elektrisches Stromerzeugungsgerät, einen Gleichstrom-Energiespeicher, einen autonomen Umrichter mit einem Steuerungssystem, und Lasten auf. Mittels eines Nachbar-Netzverbindungs-Umrichters kann Energie in einen anderen Stromversorger und Stromverbraucher übertragen werden. Die Frequenz der Wechselspannung jedes Stromversorgers und Stromverbrauchers steigt mit dem Ladezustand des Energiespeichers. Der Energieausgleich erfolgt von dem Stromversorger und Stromverbraucher mit der höheren Frequenz zu dem mit der niedrigeren Frequenz.

### Darstellung der Erfindung

Die Aufgabe der Erfindung besteht daher darin, eine Verbesserung gegenüber dem Stand der Technik zu erzielen und die Nachteile des Standes der Technik zumindest teilweise zu vermeiden. Insbesondere soll die Erfindung die Bereitstellung und den Betrieb von elektrischen Energieversorgungseinheiten ermöglichen, welche möglichst zuverlässig, flexibel einsetzbar und/oder erweiterbar sind. Vorzugsweise sollen sich die elektrischen Energieversorgungseinheiten auch kostengünstig betreiben und unterhalten lassen.

Die Lösung der Aufgabe ist durch die Merkmale des Anspruchs 1 definiert. Gemäss der Erfindung umfasst eine Steuerung für eine elektrische Energieversorgungseinheit einen ersten Füllstandseingang, an den ein erster Füllstand eines ersten Energiespeichers der elektrischen Energieversorgungseinheit übertragbar ist. Zudem umfasst die Steuerung einen weiteren Füllstandseingang, an den ein weiterer Füllstand eines optionalen weiteren Energiespeichers einer weiteren elektrischen Energieversorgungseinheit übertragbar ist. Ferner umfasst die Steuerung einen Soll-Wechselspannungsermittler, der dazu ausgebildet ist, eine Soll-Wechselspannung unter Berücksichtigung des ersten Füllstands und/oder des weiteren Füllstands zu ermitteln. Ausserdem umfasst die Steuerung einen Soll-Wechselspannungsausgang, von dem die Soll-Wechselspannung an einen Wechselspannungserzeuger der elektrischen Energieversorgungseinheit übertragbar ist.

Unter einer Steuerung ist grundsätzlich eine Vorrichtung zu verstehen, die ihre Ausgangsgrösse oder Ausganggrössen abhängig von ihren Eingangsgrössen bereitstellt. Die erfindungsgemässe Steuerung kann auch eine Regelung beinhalten, um die Auswirkungen von Störungen klein zu halten und/oder so zu beeinflussen, dass sie einer gewünschten zeitlichen Änderung folgen.

Die Steuerung kann einen oder mehrere Mikro-Kontroller aufweisen zur Erledigung der Steuer- und Regelaufgaben.

Mit Füllstand ist die Energie gemeint, die in einem Energiespeicher gespeichert ist, d.h. die verfügbare Energie eines Energiespeichers. Dabei kann die verfügbare Energie vom zeitlichen Verlauf einer Last abhängig sein. Folglich kann auch der Füllstand von der Last abhängig sein, insbesondere sogar von der zukünftigen Last. Der Füllstand kann auch als relative Grösse dargestellt werden, in dem die verfügbare Energie auf die maximale Energie eines vollen Energiespeichers bezogen wird. In diesem Fall hat ein voller Energiespeicher einen Füllstand von 100% und ein leerer Energiespeicher hat einen Füllstand von 0%.

Insbesondere kann unter Füllstand auch eine elektrische Ladung, die in einem Energiespeicher gespeichert ist, d.h. eine verfügbare Ladung, gemeint sein. Eine relative Darstellung des Füllstandes kann in diesem Fall dadurch erfolgen, dass die verfügbare Ladung auf die maximale Ladung eines vollen Energiespeichers bezogen wird.

Unter der Soll-Wechselspannung ist der zeitliche Verlauf einer Wechselspannung zu verstehen, die eine elektrische Energieversorgungseinheit zur Verfügung stellen kann, wobei die Soll-Wechselspannung von der absoluten Grösse der tatsächlichen Wechselspannung verschieden sein kann. Der zeitliche Verlauf der Soll-Wechselspannung kann durch eine Frequenz, einen Effektivwert und einen Nulldurchgangszeitpunkt beschrieben werden. Im Folgenden wird davon ausgegangen, dass gleiche Frequenzen auch gleiche Nulldurchgänge haben.

Unter "übertragbar" ist zu verstehen, dass die erfindungsgemässe Steuerung im Betrieb so mit einer erfindungsgemässen elektrischen Energieversorgungseinheit verbunden werden kann oder ist, dass die erforderlichen Betriebsdaten der elektrischen Energieversorgungseinheit, wie beispielsweise der erste Füllstand des ersten Energiespeichers, an die erfindungsgemässe Steuerung übertragen werden können. Ferner kann eine weitere elektrische Energieversorgungseinheit elektrisch leitend mit der elektrischen Energieversorgungseinheit verbunden sein, wobei von der weiteren elektrischen Energieversorgungseinheit ebenfalls Betriebsdaten an die erfindungsgemässe Steuerung übertragen werden können, wie beispielsweise der weitere Füllstand des weiteren Energiespeichers der weiteren Energieversorgungseinheit. Für die eigentliche Übertragung kommen alle bekannten Übertragungsverfahren in Betracht, wie beispielsweise drahtgebundene Übertragungsverfahren und/oder funkbasierte Übertragungsverfahren.

Die erfindungsgemässe Steuerung kann eine elektrische Energieversorgungseinheit, die elektrisch leitend mit einer weiteren elektrischen Energieversorgungseinheit verbunden ist, unter Berücksichtigung eines Betriebswerts der weiteren Steuerung der weiteren elektrischen Energieversorgungseinheit, wie beispielsweise des weiteren Füllstands, steuern. Mit der erfindungsgemässen Steuerung ist es möglich, einen Verbund bestehend aus einer Vielzahl von elektrischen Energieversorgungseinheiten ohne eine zentrale Steuerung zu steuern. Der Ausfall einer Steuerung führt auch nicht zum Ausfall aller elektrischen Energieversorgungseinheiten, d. h. des gesamten Verbundes, sondern nur zum Ausfall der zugehörigen elektrischen Energieversorgungseinheit. Damit kann eine zuverlässige Energieversorgung gewährleistet werden. Beim Erweitern oder Verkleinern des Verbundes, d.h. beim Hinzufügen oder Entfernen von elektrischen Energieversorgungseinheiten aus dem Verbund, muss an den verbleibenden Steuerungen nichts geändert werden, und sie können alle weiter verwendet werden. Erweiterungen des Verbundes sind örtlich überall leicht möglich. Da es nicht erforderlich ist, die Steuerung oder die elektrische Energieversorgungseinheit mit einem öffentlichen elektrischen Versorgungsnetz zu verbinden, können die Steuerung und die elektrische Energieversorgungseinheit sehr flexibel und praktisch überall eingesetzt werden. Wie es sich gezeigt hat, lassen sich elektrische Energieversorgungseinheiten mit erfindungsgemässen Steuerungen im Besonderen auch kostengünstig betreiben und unterhalten.

In einer Ausführungsform der Steuerung ist der Soll-Wechselspannungsermittler dazu ausgebildet, eine Soll-Frequenz der Soll-Wechselspannung unter Berücksichtigung des ersten Füllstands und/oder des weiteren Füllstands zu ermitteln, und/oder die Steuerung ist dazu ausgebildet, aus einer weiteren Frequenz einer weiteren Wechselspannung eines weiteren Wechselspannungserzeugers der weiteren elektrischen Energieversorgungseinheit den weiteren Füllstand des weiteren Energiespeichers zu ermitteln.

Der Vorteil dieser Ausführungsform ist, dass die Frequenz der Wechselspannung der elektrischen Energieversorgungseinheit genutzt werden kann, um beispielsweise den weiteren Füllstand des weiteren Energiespeichers der weiteren elektrischen Energieversorgungseinheit an die Steuerung zu übertragen. Zudem ist die Steuerung in der Lage, aus der weiteren Frequenz einer weiteren Wechselspannung einer weiteren elektrischen Energieversorgungseinheit auf den weiteren Füllstand der weiteren elektrischen Energieversorgungseinheit zu schliessen. Neben den leistungsführenden Kabeln zwischen den elektrischen Energieversorgungen sind keine zusätzlichen Signal- oder Datenleitungen erforderlich, und auch keine Funkübertragungsstrecken.

In einer weiteren Ausführungsform der Steuerung ist der Soll-Wechselspannungsermittler so ausgebildet, dass die Soll-Frequenz im Wesentlichen der weiteren Frequenz entspricht, wenn die weitere elektrische Energieversorgungseinheit elektrisch leitend mit der elektrischen Energieversorgungseinheit verbunden ist. Andernfalls wird die Soll-Frequenz im Wesentlichen unter Berücksichtigung des ersten Füllstands ermittelt.

Der Vorteil dieser Ausführungsform ist, dass die Steuerung die Wechselspannung der elektrischen Energieversorgungseinheit mit der Wechselspannung einer weiteren elektrischen Energieversorgungseinheit, sofern die beiden elektrischen Energieversorgungseinheiten elektrisch leitend miteinander verbunden sind, synchronisieren kann. Und wenn keine weitere elektrische Energieversorgungseinheit verbunden ist, kann die Steuerung mittels der Soll-Frequenz den ersten Füllstand des ersten Energiespeichers der elektrischen Energieversorgungseinheit an eine angeschlossene Last übertragen. Gewisse Lasten können die Frequenz der Wechselspannung der elektrischen Energieversorgungseinheit nutzen, um sich beispielsweise abzuschalten oder zuzuschalten. Somit stellt die Steuerung den Lasten eine Möglichkeit zur Optimierung der Energienutzung der elektrischen Energieversorgungseinheit zur Verfügung.

In einer weiteren Ausführungsform der Steuerung ist der Soll-Wechselspannungsermittler so ausgebildet, dass die Soll-Frequenz im Wesentlichen der weiteren Frequenz entspricht, wenn die weitere elektrische Energieversorgungseinheit elektrisch leitend mit der elektrischen Energieversorgungseinheit verbunden ist und wenn der weitere Füllstand grösser als der Füllstand ist. Andernfalls wird die Soll-Frequenz im Wesentlichen unter Berücksichtigung des ersten Füllstands ermittelt.

Folglich gibt bei zwei elektrisch leitend miteinander verbundenen elektrischen Energieversorgungseinheiten die Steuerung der beiden Steuerungen, deren elektrische Energieversorgungseinheit den grösseren Füllstand hat, die Soll-Frequenz der Wechselspannung vor, und die Steuerung der beiden Steuerungen, deren elektrische Energieversorgungseinheit einen kleineren Füllstand hat, folgt der vorgegebenen Soll-Frequenz. Gleiches gilt auch für mehr als zwei elektrisch leitend miteinander verbundene Energieversorgungseinheiten. Somit kann die Steuerung den Wert des grössten Füllstandes von zwei oder mehr elektrisch miteinander verbundenen elektrischen Energieversorgungseinheiten in Form der entsprechenden Soll-Frequenz der Wechselspannung an alle anderen Steuerungen und auch an Lasten übermitteln, die an den elektrisch miteinander verbunden elektrischen Energieversorgungseinheiten angeschlossen sind.

Alternativ kann auch die Steuerung der beiden Steuerungen, deren elektrische Energieversorgungseinheit den kleineren Füllstand hat, die Soll-Frequenz der Wechselspannung vorgeben und die Steuerung der beiden Steuerungen, deren elektrische Energieversorgungseinheit den grösseren Füllstand hat, folgt der vorgegebenen Soll-Frequenz.

In einer besonderen Ausführungsform der Steuerung kann der Soll-Wechselspannungsermittler den ersten Füllstand derart berücksichtigen, dass die Soll-Frequenz stetig mit dem ersten Füllstand steigt.

Damit kann die Steuerung eine Kompatibilität der elektrischen Energieversorgungseinheit mit anderen Makro- oder Mikro-Grids herstellen, die in der Regel eine Frequenz der Wechselspannung aufweisen, die stetig mit der Grid-Last sinkt. Dabei entspricht eine grosse Grid-Last einem kleinen ersten Füllstand, und eine kleine Grid-Last entspricht einem grossen ersten Füllstand. Dies ist insbesondere bei Erweiterungen von bestehenden Mikro-Grids mit elektrischen Energieversorgungseinheiten, die die erfindungsgemässe Steuerung aufweisen, vorteilhaft.

In einer weiteren besonderen Ausführungsform der Steuerung kann der Soll-Wechselspannungsermittler den ersten Füllstand derart berücksichtigen, dass die Soll-Frequenz zumindest in einem Bereich linear vom ersten Füllstand abhängt.

Der Vorteil dieser Ausführungsform besteht darin, dass sie besonders einfach zu realisieren ist.

In einer anderen Ausführungsform der Steuerung kann der Soll-Wechselspannungsermittler den ersten Füllstand derart berücksichtigen, dass die Soll-Frequenz bei einem ersten Füllstand von 0% einen Wert haben kann im Bereich von 82% - 98% einer Nennfrequenz, insbesondere 84% - 96% der Nennfrequenz, im Speziellen 86% - 94% der Nennfrequenz, im Besonderen 88% - 92% der Nennfrequenz, oder im ganz Besonderen 90% - 91% der Nennfrequenz, und wobei die Nennfrequenz insbesondere 50Hz oder 60Hz betragen kann.

Unter der Nennfrequenz ist die Frequenz zu verstehen, die beispielsweise ein Makro-Grid im normalen Betrieb aufweist. Die Nennfrequenz ist in Europa üblicherweise 50Hz, in Nordamerika beträgt die Nennfrequenz 60Hz.

Damit wird eine Kompatibilität zu einer Vielzahl von verschiedenen Makro- und Mikro-Grids erreicht.

In noch einer anderen Ausführungsform der Steuerung kann der Soll- Wechselspannungsermittler den ersten Füllstand derart berücksichtigen, dass die Soll-Frequenz bei einem ersten Füllstand von 100% im Wesentlichen einer Nennfrequenz entspricht, wobei die Nennfrequenz insbesondere 50Hz oder 60Hz betragen kann.

Damit wird eine Kompatibilität zu einer Vielzahl von verschiedenen Makro- und Mikro-Grids erreicht, insbesondere zu jenen, die eine Nennfrequenz von 50Hz und/oder 60Hz haben.

In noch einer weiteren Ausführungsform der Steuerung kann die Steuerung einen Maximalleistungsregler für eine elektrische Energiequelle der elektrischen Energieversorgungseinheit umfassen.

Ein Maximalleistungsregler ist eine Vorrichtung, bei dem die elektrische Belastung der elektrischen Energiequelle so angepasst werden kann, dass der elektrischen Energiequelle die größte mögliche Leistung entnommen werden kann. Derartige Regler sind dem Fachmann an sich bekannt.

Damit kann die Steuerung erreichen, dass der erste Energiespeicher schnellstmöglich gefüllt wird oder dass der erste Energiespeicher minimal belastet wird, weil die Last bei maximaler Quellenleistung der Energiequelle im Wesentlichen aus der Energiequelle gespeist wird und nicht aus dem ersten Energiespeicher.

Der Maximalleistungsregler muss nicht zwingend die elektrische Belastung der elektrischen Energiequelle so anpassen, dass der elektrischen Energiequelle die größte mögliche Leistung entnommen wird. Es sind auch Betriebszustände möglich, bei denen der Maximalleistungsregler die elektrische Belastung der elektrischen Energiequelle so anpasst, dass der elektrischen Energiequelle eine geringere als die größte mögliche Leistung entnommen wird, oder sogar gar keine.

In einer besonderen Ausführungsform umfasst die Steuerung zusätzlich einen Leistungsüberschusseingang, an den ein Leistungsüberschuss einer elektrischen Energiequelle übertragbar ist. Dabei ist der Soll-Wechselspannungsermittler zusätzlich dazu ausgebildet, bei einem ersten Füllstand von 100% die Soll-Frequenz in Abhängigkeit des Leistungsüberschusses zu ermitteln.

Unter Leistungsüberschuss ist die grösste mögliche Leistung der elektrischen Energiequelle abzüglich der tatsächlich abgegebenen Leistung zu verstehen. Der Leistungsüberschuss kann auch relativ angegeben werden. Ein Leistungsüberschuss von 100% bedeutet, dass die Energiequelle keine Leistung abgibt, obwohl sie dazu bei geeigneter Last in der Lage wäre.

Damit kann die Steuerung an die Last der elektrischen Energieversorgungseinheit die Information übertragen, dass ein Leistungsüberschuss vorliegt. Gewisse Lasten, die nicht zeitkritisch sind und einen relativ hohen Energieverbrauch haben, wie zum Beispiel Kältespeicher oder auch Wasserpumpen, die beispielsweise Wasser aus einem Brunnen in ein höhergelegenes Reservoir pumpen, können diese Information nutzen, um sich bei einem Leistungsüberschuss einzuschalten. Somit stellt die Steuerung eine weitere Möglichkeit zur Optimierung der Energienutzung der elektrischen Energieversorgungseinheit zur Verfügung.

In einer ganz besonderen Ausführungsform der Steuerung kann der Soll-Wechselspannungsermittler den ersten Füllstand derart berücksichtigen, dass die Soll-Frequenz stetig mit dem Leistungsüberschuss steigt.

Damit wird eine Kompatibilität zu weiteren Makro- und Mikro-Grids erreicht.

In einer weiteren ganz besonderen Ausführungsform der Steuerung kann der Soll-Wechselspannungsermittler den ersten Füllstand derart berücksichtigen, dass die Soll-Frequenz zumindest in einem Bereich linear vom Leistungsüberschuss abhängt.

Der Vorteil dieser Ausführungsform ist, dass sie besonders einfach zu realisieren ist.

In einer weiteren Ausführungsform der Steuerung kann der Soll-Wechselspannungsermittler den ersten Füllstand derart berücksichtigen, dass die Soll-Frequenz bei einem ersten Füllstand von 100% im Wesentlichen einer Nennfrequenz entspricht, wenn der Leistungsüberschuss gleich Null ist. Oder die Soll-Frequenz kann bei einem ersten Füllstand von 100% einen Wert haben von mehr als 100% bis zu 104% der Nennfrequenz, wenn der Leistungsüberschuss maximal ist. Die Nennfrequenz kann insbesondere 50Hz oder 60Hz betragen.

Damit wird eine Kompatibilität zu weiteren verschiedenen Makro- und Mikro-Grids erreicht.

In einer noch weiteren Ausführungsform der Steuerung ist der Soll-Wechselspannungsermittler zusätzlich dazu ausgebildet, einen Soll-Effektivwert der Soll-Wechselspannung in Abhängigkeit von einer Füllstandsdifferenz zu ermitteln. Die Füllstandsdifferenz berechnet sich aus dem ersten Füllstand minus den weiteren Füllstand.

Eine Füllstandsdifferenz, insbesondere von elektrisch leitend miteinander verbundenen elektrischen Energieversorgungseinheiten, ist grundsätzlich unerwünscht und sollte möglichst vermieden werden. Um diese Füllstandsdifferenz beeinflussen zu können, wird in einem Zwischenschritt zunächst der Soll-Effektivwert der Wechselspannung der elektrischen Energieversorgungseinheit ermittelt. Der Soll-Effektivwert der Wechselspannung kann dabei auf unterschiedlichste Art und Weise variiert werden. Beispielsweise ist es möglich, den Beginn einer Halbwelle der Soll-Wechselspannung zu verzögern oder vorzuziehen, und/oder das Ende einer Halbwelle zu verzögern oder vorzuziehen. Auch ist es z.B. möglich, die Amplitude zu variieren. Bei einer elektrischen Energieversorgungseinheit mit Puls-Weiten-Modulation der Wechselspannung ist es möglich, die Pulsweiten zu variieren. Damit stellt die Steuerung eine Zwischengrösse, namentlich den Soll-Effektivwert der Wechselspannung, zur Verfügung, um die Füllstandsdifferenz beeinflussen zu können. Zudem kann mit dieser Zwischengrösse "Soll-Effektivwert" sehr schnell auf eine Füllstandsdifferenz reagiert werden. Bei einer üblichen Nennfrequenz von 50Hz oder 60Hz beträgt die Dauer einer Halbwelle im Wesentlichen 10ms beziehungsweise 8.3ms, d.h. alle 10ms beziehungsweise 8.3ms kann der Soll-Effektivwert geändert werden. Eine signifikante Änderung der Füllstandsdifferenz dauert in der Regel einige Minuten, wenn man davon ausgeht, dass Inselsysteme üblicherweise im Laufe eines Tages (24 Stunden) einen kompletten Lade-Entladezyklus durchlaufen.

In einer bevorzugten Ausführungsform der Steuerung ist der Soll-Wechselspannungsermittler zusätzlich dazu ausgebildet, den Soll-Effektivwert der Soll-Wechselspannung so zu regeln, dass die Füllstandsdifferenz gegen Null konvergiert.

Damit wird erreicht, dass jeder einzelne Energiespeicher eines Verbundes von verschiedenen elektrischen Energieversorgungseinheiten im stationären Zustand den gleichen Füllstand hat. Dies wiederum führt dazu, dass alle Energiespeicher optimal genutzt werden, da sie idealerweise alle zur gleichen Zeit einen Füllstand von Null erreichen. Zudem werden die elektrischen Energieversorgungseinheiten und insbesondere die Energiespeicher einer gleichen Zyklenbelastung und damit auch einer im Wesentlichen gleichen Alterung unterworfen. Das wiederum vereinfacht den Unterhalt der elektrischen Energieversorgungseinheiten, da deren Lebensdauerende zur gleichen Zeit erreicht werden kann und damit alle elektrischen Energieversorgungseinheiten oder einzelne ihrer Komponenten zum gleichen Zeitpunkt ausgetauscht werden können.

Vorteilhafterweise kann der Soll-Wechselspannungsermittler dazu ausgebildet sein, den Soll-Effektivwert der Soll-Wechselspannung so zu steuern, dass die Füllstandsdifferenz gegen Null konvergiert. Das Steuern des Soll-Effektivwertes der Soll-Wechselspannung kann ohne eine Messung einer Wechselspannung an einem zweiten Anschluss eines Wechselspannungserzeugers, und insbesondere ohne eine Messung eines Effektivwertes der Wechselspannung an dem zweiten Anschluss des Wechselspannungserzeugers, erfolgen.

In einer bevorzugten Ausführungsform der Steuerung ist der Soll-Wechselspannungsermittler zusätzlich dazu ausgebildet, den Soll-Effektivwert der Soll-Wechselspannung in Abhängigkeit von einem vom Wechselspannungserzeuger abgegebenen Strom zu ermitteln.

Damit kann der vom Wechselspannungserzeuger abgegebene Strom in Abhängigkeit von der Füllstandsdifferenz geregelt oder gesteuert werden.

Der vom Wechselspannungserzeuger abgegebene Strom fliesst bevorzugt durch einen zweiten Anschluss des Wechselspannungserzeugers.

In einer bevorzugten Ausführungsform der Steuerung ist der Soll-Wechselspannungsermittler zusätzlich dazu ausgebildet, die Soll-Wechselspannung für zumindest eine Sollwechselspannungsperiode auf Null zu setzen, wenn innerhalb des Wechselspannungserzeugers eine Überspannung auftritt.

Dies hat den Vorteil, dass beispielsweise bei einem Lastabwurf bei einer elektrischen Energieversorgungseinheit ein von dem Wechselspannungserzeuger abgegebener Strom unverzüglich abgeschaltet werden kann und/oder erst nach einer gewissen Zeit von einer oder mehreren Sollwechselspannungsperioden wieder zugeschaltet werden kann.

Vorteilhafterweise kann die Spannung an einem Zwischenkreis innerhalb des Wechselspannungserzeugers gemessen werden. Dies ermöglicht, auf eine Messung der Wechselspannung des Wechselspannungserzeugers zu verzichten.

In einer weiteren bevorzugten Ausführungsform der Steuerung umfasst der Soll-Wechselspannungsermittler zusätzlich einen Lastleistungseingang, an den eine Lastleistung einer an die elektrische Energieversorgungseinheit angeschlossenen Last übertragbar ist. Des Weiteren umfasst der Soll-Wechselspannungsermittler insbesondere zusätzlich einen Erzeugerleistungseingang, an den eine von dem Wechselspannungserzeuger der elektrischen Energieversorgungseinheit abgegebene Erzeugerleistung übertragbar ist. Dabei ist der Soll-Wechselspannungsermittler zusätzlich dazu ausgebildet, den Soll-Effektivwert so zu ermitteln, dass die Erzeugerleistung grösser als die Lastleistung ist, wenn der erste Füllstand grösser als der weitere Füllstand ist. Ferner ist der Soll-Wechselspannungsermittler zusätzlich dazu ausgebildet, den Soll-Effektivwert so zu ermitteln, dass die Erzeugerleistung kleiner als die Lastleistung ist, wenn der erste Füllstand kleiner als der weitere Füllstand ist. Zudem ist der Soll-Wechselspannungsermittler zusätzlich dazu ausgebildet, den Soll-Effektivwert so zu ermitteln, dass die Erzeugerleistung gleich der Lastleistung ist, wenn der erste Füllstand dem weiteren Füllstand entspricht.

Die Steuerung kann die elektrische Energieversorgungseinheit so steuern, dass die weitere elektrische Energieversorgungseinheit je nach ihrem weiteren Füllstand entlastet oder zusätzlich belastet wird. Beispielsweise kann die Lastaufteilung zwischen den elektrischen Energieversorgungseinheiten so erfolgen, dass die elektrische Energieversorgungseinheit mit einem Energiespeicher mit einer grösseren Kapazität, zum Beispiel auf Grund eines kleineren Alterungszustands, mehr belastet wird als eine elektrische Energieversorgungseinheit mit einem Energiespeicher mit einer kleineren Kapazität.

Somit kann eine Lastverteilung zwischen verschiedenen elektrisch leitend miteinander verbundenen elektrischen Energieversorgungseinheiten erzielt werden, die dazu führt, dass sich alle Füllstände mit der Zeit angleichen.

In einer weiteren Ausführungsform umfasst die Steuerung zusätzlich einen Austauschleistungseingang, an den eine Austauschleistung, die von der elektrischen Energieversorgungseinheit zu der weiteren elektrischen Energieversorgungseinheit fliesst, übertragbar ist. Ferner umfasst die Steuerung insbesondere zusätzlich einen Schutzschalter, der dazu ausgebildet ist, eine elektrisch leitende Verbindung zwischen der elektrischen Energieversorgungseinheit und der weiteren elektrischen Energieversorgungseinheit herzustellen, und die elektrisch leitende Verbindung zu trennen, wenn entweder die Austauschleistung kleiner als Null ist und der erste Füllstand gleich oder kleiner als ein erster vorbestimmter Füllstandsschwellwert ist, oder wenn die Austauschleistung grösser als Null ist und der erste Füllstand gleich oder kleiner als ein zweiter vorbestimmter Füllstandsschwellwert ist.

Der Vorteil dieser Ausführungsform besteht in verschiedenen Schutzmöglichkeiten für die elektrische Energieversorgungseinheit, insbesondere deren Energiespeicher. Zum einen bietet diese Ausführungsform einen Schutz vor Tiefentladung. Zum anderen wird die Last vor der weiteren elektrischen Energieversorgungseinheit geschützt, falls die weitere elektrische Energieversorgungseinheit über längere Zeit Leistung von der elektrischen Energieversorgungseinheit bezieht und dabei ein erster Füllstandsschwellwert erreicht oder unterschritten wird.

Ein weiterer Vorteil besteht in einer Schutzmöglichkeit für die weitere elektrische Energieversorgungseinheit, in dem die weitere elektrische Energieversorgungseinheit zum Beispiel vor einer fehlerhaften Last der elektrischen Energieversorgungseinheit geschützt wird.

Nach behobenem Fehler kann der Schutzschalter manuell wieder eingeschaltet werden oder zum Einschalten durch die Steuerung freigegeben werden.

In einer weiteren Ausführungsform umfasst die Steuerung zusätzlich eine optische und/oder akustische Anzeige, die dazu ausgebildet ist, ein Warnsignal zu erzeugen, wenn die elektrisch leitende Verbindung zwischen der elektrischen Energieversorgungseinheit und der weiteren elektrischen Energieversorgungseinheit durch den Schutzschalter getrennt wurde.

Durch die optische und/oder akustische Anzeige ist es für einen Betreiber sehr einfach, die von einer Schutzabschaltung betroffene Steuerung zu identifizieren. Damit wird er unterstützt bei der Fehlersuche und der Fehlerbehebung.

In einer weiteren Ausführungsform ist der Schutzschalter so ausgebildet, dass der erste vorbestimmte Füllstandsschwellwert grösser ist als der zweite vorbestimmte Füllstandsschwellwert.

Damit wird erreicht, dass der Schutz eines Verbundes von weiteren elektrischen Energieversorgungseinheiten schon bei einem höheren ersten Füllstand der elektrischen Energieversorgungseinheit einsetzt, als der Schutz der elektrischen Energieversorgungseinheit vor dem Verbund der weiteren elektrischen Energieversorgungseinheiten.

In einer weiteren Ausführungsform ist der Soll-Wechselspannungsermittler dazu ausgebildet, eine Soll-Frequenz entsprechend einer Netzfrequenz eines öffentlichen elektrischen Versorgungsnetzes zu ermitteln, falls die elektrische Energieversorgungseinheit elektrisch leitend mit dem öffentlichen elektrischen Versorgungsnetz verbunden ist.

Auch wenn die erfindungsgemässe Steuerung die elektrische Energieversorgungseinheit ohne Verbindung mit einem öffentlichen elektrischen Versorgungsnetz (Makro-Grid) steuern kann, ist eine Verbindung und Synchronisation der elektrischen Energieversorgungseinheit mit einem öffentlichen elektrischen Versorgungsnetz möglich. Damit kann zusätzlich elektrische Energie bereitgestellt werden, um beispielsweise den ersten Füllstand des ersten Energiespeichers zu erhöhen. Oder die elektrische Energieversorgungseinheit kann Energie an das öffentliche elektrische Versorgungsnetz abgeben. Die Verbindung der elektrischen Energieversorgungseinheit mit dem öffentlichen elektrischen Versorgungsnetz erfolgt also so, dass ein Energiefluss vom öffentlichen elektrischen Versorgungsnetz zur elektrischen Energieversorgungseinheit, oder umgekehrt, möglich ist.

In einer weiteren Ausführungsform umfasst die Steuerung zusätzlich einen Datenspeicher zum Speichern von Betriebsdaten der elektrischen Energieversorgungseinheit.

Bei den Betriebsdaten der Energieversorgungseinheit kann es sich um Daten der einzelnen Komponenten der elektrischen Energieversorgungseinheit handeln, wie beispielsweise die Quellenleistung, den Leistungsüberschuss, den ersten Füllstand, die Lastleistung, die Austauschleistung, und/oder die Erzeugerleistung. Zu den Betriebsdaten der Energieversorgungseinheit kann auch der weitere Füllstand gehören, der von der weiteren elektrischen Energieversorgungseinheit an die Steuerung übertragen wird.

Bei der Quellenleistung handelt es sich um die tatsächlich von der elektrischen Energiequelle der elektrischen Energieversorgungseinheit abgegebene Leistung.

Der Datenspeicher ermöglicht eine spätere Auswertung oder weitere Verwendung der gespeicherten Betriebsdaten. Dies ist im Hinblick auf eine Optimierung der Steuerung vorteilhaft.

In einer vorteilhaften Ausführungsform umfasst die Steuerung zusätzlich eine Prognoseeinheit zum Prognostizieren eines ersten zukünftigen Füllstands und/oder eines weiteren zukünftigen Füllstands.

Mit der Kenntnis des ersten zukünftigen Füllstands und/oder des weiteren zukünftigen Füllstands können weitere Optimierungen beim Betrieb der erfindungsgemässen Steuerung vorgenommen werden, wie im folgenden gezeigt wird.

In einer weiteren vorteilhaften Ausführungsform der Steuerung nutzt die Prognoseeinheit zum Prognostizieren des ersten zukünftigen Füllstands und/oder des weiteren zukünftigen Füllstands Betriebsdaten aus dem Datenspeicher.

Insbesondere bei immer wiederkehrenden Betriebsmustern ist es vorteilhaft, Betriebsdaten aus der Vergangenheit, die in einem Speicher abgelegt wurden, zur Prognose des ersten zukünftigen Füllstands zu nutzen. Damit lässt sich eine besonders grosse Genauigkeit und Zuverlässigkeit erzielen. Bei der Nutzung der Betriebsdaten aus dem Datenspeicher können auch Lernalgorithmen, wie beispielsweise neuronale Netze, verwendet werden.

Die Steuerung kann auch dazu ausgebildet sein, vorbestimmte Lastmuster zu erkennen und diese bei der Soll-Frequenzermittlung zu berücksichtigen.

In einer weiteren Ausführungsform umfasst die Steuerung zusätzlich eine Übermittlungseinheit zum Übermitteln von Betriebsdaten, insbesondere Betriebsdaten aus einem Datenspeicher, an eine externe Datenbank und/oder einen externen Rechner.

Der Vorteil der Übermittlung von Betriebsdaten an die externe Datenbank und/oder den externen Rechner liegt darin, dass der Rechner und/oder die Datenbank weitere Auswertungen und/oder weitere Verarbeitung der Betriebsdaten vornehmen können, wie beispielsweise eine Rechnungserstellung.

In einer besonders vorteilhaften Ausführungsform der Steuerung ist der Soll-Wechselspannungsermittler zusätzlich dazu ausgebildet, die Soll-Wechselspannung unter Berücksichtigung eines ersten zukünftigen Füllstands und/oder eines weiteren zukünftigen Füllstands zu ermitteln.

Damit lässt sich die Ausnutzung des ersten Energiespeichers der elektrischen Energieversorgungseinheit verbessern, da nicht aktuelle Füllstände sondern prognostizierte zukünftige Füllstände bei der Steuerung der elektrischen Energieversorgungseinheit verwendet werden.

Ein weiterer Aspekt der vorliegenden Erfindung betrifft eine elektrische Energieversorgungseinheit umfassend eine erfindungsgemässe Steuerung, einen ersten Energiespeicher und einen Wechselspannungserzeuger mit einem ersten Anschluss und einem zweiten Anschluss. Der erste Anschluss des Wechselspannungserzeugers ist elektrisch leitend mit dem ersten Energiespeicher verbunden. Der Wechselspannungserzeuger ist dazu ausgebildet, eine einer Soll-Wechselspannung entsprechende Wechselspannung am zweiten Anschluss zu erzeugen.

Unter einem Energiespeicher ist ein Speicher für elektrische Energie zu verstehen.

Unter einem Wechselspannungserzeuger ist jeder Umrichter zu verstehen, der eine Wechselspannung erzeugen kann.

Die Nennwerte für die Wechselspannung können beispielsweise bei 120V/60Hz und/oder 230V/50Hz liegen.

Die Dauerleistung des Wechselspannungserzeugers kann im Bereich von 1W bis 1MW, insbesondere von 10W bis 10 KW, im Speziellen von 100W bis 500W, und im ganz Speziellen von 200W-300W liegen.

Die erfindungsgemässe elektrische Energieversorgungseinheit kann auch ohne Anschluss an ein öffentliches elektrisches Versorgungsnetz (Makro-Grid) eine Wechselspannung bereitstellen, die im Wesentlichen einer Wechselspannung eines öffentlichen elektrischen Versorgungsnetzes entspricht.

Die erfindungsgemässe elektrische Energieversorgungseinheit kann einfach und auch von einem Nicht-Fachmann installiert werden. Ferner kann die elektrische Energieversorgungseinheit wechselspannungsseitig, beispielsweise an ihrem zweiten Anschluss, mit einer oder mehreren weiteren elektrischen Energieversorgungseinheiten elektrisch leitend verbunden werden, so dass ein Verbund von parallel geschalteten elektrischen Energieversorgungseinheiten herstellbar ist. D.h. der Verbund ist beliebig erweiterbar von einer einzigen elektrischen Energieversorgungseinheit bis zu einer beliebigen, unbegrenzten Anzahl von elektrischen Energieversorgungseinheiten.

In einer weiteren Ausführungsform der elektrischen Energieversorgungseinheit kann der erste Energiespeicher eine Spannung aufweisen, die im Wesentlichen eine Gleichspannung ist.

Dies kann das Zusammenspiel mit anderen Komponenten der elektrischen Energieversorgungseinheit vereinfachen, wenn diese auch mit Gleichspannungen arbeiten.

In einer weiteren Ausführungsform der elektrischen Energieversorgungseinheit ist der erste Energiespeicher ein elektrochemischer Energiespeicher.

Elektrochemische Energiespeicher sind in grosser Zahl für verschiedenste Einsatzbedingungen kommerziell verfügbar und daher mit wirtschaftlichem Vorteil in der elektrischen Energieversorgungseinheit einsetzbar.

In einer weiteren Ausführungsform der elektrischen Energieversorgungseinheit ist der erste Energiespeicher eine Brennstoffzelle.

Da Brennstoffzellen umweltfreundlich und in der Regel wartungsfrei sind, können sie mit Vorteil in der elektrischen Energieversorgungseinheit eingesetzt werden. Solange der Brennstoff, den die Brennstoffzelle im Betrieb benötigt, vorhanden ist, kann zudem von einem ersten Füllstand von 100% ausgegangen werden.

In einer weiteren Ausführungsform der elektrischen Energieversorgungseinheit ist der erste Energiespeicher wiederaufladbar.

Dies ist insbesondere von Vorteil, wenn die elektrische Energieversorgungseinheit über eine Energiequelle verfügt, deren elektrische Energie dann in dem ersten Energiespeicher gespeichert werden kann.

In einer weiteren Ausführungsform der elektrischen Energieversorgungseinheit weist der erste Energiespeicher eine oder mehrere Primärzellen des Typs Li-Ion, Li-Polymer, Li-Mangan, Li-Eisenphosphat, Lithium-Luft, Li-Titanat, Li-Schwefel, Na-NiCI, Na-S, Na-Ion, Ni-Cd, Ni-Fe, Ni-H₂, Ni-MH, Ni-ZN und/oder Blei auf.

Primärzellen des oben genannten Typs können vorteilhaft eingesetzt werden, weil sie in grosser Zahl hergestellt werden und wirtschaftlich attraktiv sind.

In einer weiteren Ausführungsform der elektrischen Energieversorgungseinheit ist der erste Energiespeicher eine wartungsfreie und/oder wartungsarme Bleibatterie.

Bleibatterien werden in besonders grossen Stückzahlen hergestellt und in grosser Variantenvielfalt speziell auch für zyklische Belastungen, weshalb sie besonders vorteilhaft sind für den Einsatz in der erfindungsgemässen elektrischen Energieversorgungseinheit. Zudem gibt es Normen für Bleibatterien, so dass die Spezifikation besonders einfach ist und auch Ersatzbleibatterien gut verfügbar sind.

Mit wartungsfreien oder wartungsarmen Bleibatterien, beispielsweise mit ventilgeregelten Bleibatterien vom Typ VRLA (valve regulated lead acid) und/oder verschlossenen Bleibatterien vom Typ SLA (sealed lead acid) werden zudem die Wartungskosten der elektrischen Energieversorgungseinheit reduziert.

Bleibatterien mit OPzS-Elektroden können eingesetzt werden, weil sie eine vergleichsweise lange Lebensdauer haben und daher besonders wirtschaftlich sind.

In einer weiteren Ausführungsform der elektrischen Energieversorgungseinheit weist der erste Energiespeicher eine Anzahl von 3-24, insbesondere 4, 6, 8, 10, 12 oder 20 in Reihe geschalteter Primärzellen auf.

Damit kann eine Spannungsanpassung an die Erfordernisse des Wechselspannungserzeugers und/oder der elektrischen Energiequelle erreicht werden.

In einer weiteren Ausführungsform kann die elektrische Energieversorgungseinheit zusätzlich einen Füllstandsermittler zum Ermitteln eines ersten Füllstands des ersten Energiespeichers umfassen.

Damit wird die elektrische Energieversorgungseinheit unabhängig von einer Übermittlung des ersten Füllstands auf anderem Wege oder auf andere Art und Weise ermöglicht. Füllstandsermittler sind für eine Vielzahl von Energiespeichern bekannt, insbesondere für Bleibatterien.

In einer weiteren Ausführungsform der elektrischen Energieversorgungseinheit ist der Füllstandsermittler dazu ausgebildet, beim Ermitteln des ersten Füllstands ein oder mehrere Betriebsdaten des ersten Energiespeichers zu berücksichtigen.

Dadurch kann die Genauigkeit des Füllstandsermittlers verbessert werden.

In einer weiteren Ausführungsform der elektrischen Energieversorgungseinheit können die Betriebsdaten des ersten Energiespeichers ausgewählt sein aus der Gruppe: elektrische Spannung des ersten Energiespeichers, Strombilanz des ersten Energiespeichers, Temperatur des ersten Energiespeichers, Innenwiderstand des ersten Energiespeichers und/oder Elektrolytkonzentration des ersten Energiespeichers.

Wenn der Füllstandsermittler die oben genannten Betriebsdaten des ersten Energiespeichers berücksichtigt, kann seine Genauigkeit weiter verbessert werden.

In einer weiteren Ausführungsform umfasst die elektrische Energieversorgungseinheit zusätzlich eine elektrische Energiequelle, die mit dem ersten Energiespeicher elektrisch leitend verbindbar ist.

Mit einer Energiequelle kann die Zeit verlängert werden, in der die elektrische Energieversorgungseinheit eine elektrische Energie abgeben kann.

In einer weiteren Ausführungsform der elektrischen Energieversorgungseinheit kann die elektrische Energiequelle eine elektrische Spannung aufweisen und/oder erzeugen, die im Wesentlichen eine Gleichspannung ist.

Dies kann das Zusammenspiel mit anderen Komponenten der elektrischen Energieversorgungseinheit vereinfachen, wenn diese auch mit Gleichspannungen arbeiten.

In einer weiteren Ausführungsform der elektrischen Energieversorgungseinheit ist die elektrische Energiequelle mit regenerativen Energien betreibbar.

Dadurch ist die Energiequelle, und damit auch die elektrische Energieversorgungseinheit, unabhängig vom Vorhandensein und/oder der Lieferung von beispielsweise fossilen Brennstoffen.

In einer weiteren Ausführungsform der elektrischen Energieversorgungseinheit können die regenerativen Energien ausgewählt sein aus der Gruppe: Sonnenenergie, Windenergie, Wasserkraft, Meeresenergie, Erdwärme und/oder Bioenergie.

Oben genannte Gruppe von regenerativen Energien ist gut verfügbar und daher mit Vorteil nutzbar von einer elektrischen Energiequelle der erfindungsgemässen elektrischen Energieversorgungseinheit.

In einer weiteren Ausführungsform der elektrischen Energieversorgungseinheit ist die elektrische Energiequelle ein photovoltaisches Solarpanel.

Photovoltaische Solarpanel sind in einer grossen Vielfalt kommerziell verfügbar, preislich attraktiv, langlebig und wartungsfrei.

In einer weiteren Ausführungsform umfasst die elektrische Energieversorgungseinheit zusätzlich einen Spannungswandler, der eingangsseitig mit der elektrischen Energiequelle und ausgangsseitig mit dem ersten Energiespeicher elektrisch verbunden ist.

Damit kann eine Anpassung der Spannung der elektrischen Energiequelle mit der Spannung des ersten Energiespeichers erreicht werden. Ausserdem kann mit dem Spannungswandler beispielsweise ein Betriebspunkt der elektrischen Energiequelle eingestellt werden.

In einer weiteren Ausführungsform der elektrischen Energieversorgungseinheit ist der Spannungswandler ein Gleichspannungswandler.

Dies kann das Zusammenspiel mit anderen Komponenten der elektrischen Energieversorgungseinheit vereinfachen, wenn diese auch mit Gleichspannungen arbeiten.

In einer weiteren Ausführungsform der elektrischen Energieversorgungseinheit ist der Spannungswandler so ausgebildet, dass eine von der elektrischen Energiequelle abgebbare Quellenleistung maximal sein kann.

Die von einer elektrischen Energiequelle abgebbare Quellenleistung kann beispielsweise dann maximal sein, wenn ein Maximalleistungsregler der Steuerung den Spannungswandler steuert und/oder regelt.

Damit kann erreicht werden, dass der erste Energiespeicher schnellstmöglich gefüllt wird oder dass der erste Energiespeicher minimal belastet wird, weil die Last bei maximaler Quellenleistung im Wesentlichen aus der Energiequelle gespeist wird und nicht aus dem ersten Energiespeicher.

In einer weiteren Ausführungsform der elektrischen Energieversorgungseinheit ist der Wechselspannungserzeuger ausschliesslich für einen unidirektionalen Energiefluss vom ersten Anschluss zum zweiten Anschluss ausgebildet.

Dadurch wird der Wechselspannungserzeuger einfach und preiswert in der Herstellung.

In einer weiteren Ausführungsform der elektrischen Energieversorgungseinheit ist der Wechselspannungserzeuger ein Gleichspannungs-Wechselspannungswandler.

Dadurch wird der Wechselspannungserzeuger besonders einfach und preiswert in der Herstellung.

In einer weiteren Ausführungsform der elektrischen Energieversorgungseinheit weist der Gleichspannungs-Wechselspannungswandler einen Hochsetzsteller auf.

Ein Hochsetzsteller ist eine Vorrichtung zum Erhöhen einer Gleichspannung und wird auch Aufwärtswandler genannt.

Damit können Schwankungen der Spannung des ersten Energiespeichers und/oder der Wechselspannung des Wechselspannungserzeugers ausgeglichen werden.

In einer weiteren Ausführungsform der elektrischen Energieversorgungseinheit weist der Gleichspannungs-Wechselspannungswandler einen Wechselrichter mit einem Transformator auf.

Damit kann eine galvanische Trennung zwischen einerseits der elektrischen Energiequelle und dem ersten Energiespeicher sowie andererseits der Wechselspannung am zweiten Anschluss des Wechselspannungserzeugers gewährleistet werden, was zur Sicherheit der elektrischen Energieversorgungseinheit beiträgt.

In einer weiteren Ausführungsform der elektrischen Energieversorgungseinheit ist der zweite Anschluss mit einer Last verbindbar.

Eine oder mehrere Lasten können direkt an die elektrische Energieversorgungseinheit angeschlossen werden, was nicht nur praktisch ist, sondern auch Installationsaufwand verringert, denn die elektrische Energieversorgungseinheit ist grundsätzlich dezentral platzierbar, also auch direkt bei der Last.

In einer weiteren Ausführungsform umfasst die elektrische Energieversorgungseinheit zusätzlich ein Ladegerät, welches eingangsseitig mit einem elektrischen Versorgungsnetz verbindbar ist und ausgangsseitig mit dem ersten Energiespeicher verbunden ist.

Das Ladegerät bietet den Vorteil, dass der erste Energiespeicher nicht nur aus der Energiequelle ladbar ist, sondern auch aus einem öffentlichen elektrischen Versorgungsnetz, sofern dies an der elektrischen Energieversorgungseinheit angeschlossen ist.

In einer weiteren Ausführungsform der elektrischen Energieversorgungseinheit ist das Ladegerät eingangsseitig mit dem zweiten Anschluss des Wechselspannungserzeugers (50) verbindbar.

Sofern die elektrische Energieversorgungseinheit mit einer weiteren elektrischen Energieversorgungseinheit elektrisch leitend verbunden ist, wodurch ein Inselnetzt entsteht, wie weiter untern erläutert wird, kann das Ladegerät elektrische Energie aus dem Inselnetz entnehmen und in den ersten Energiespeicher einspeisen, wodurch der erste Füllstand erhöht werden kann. Eine der entnommenen Energie entsprechende Energie kann beispielsweise von der weiteren elektrischen Energieversorgungseinheit in das Inselnetz eingespeist werden. Die eingespeiste Energie kann sowohl aus einer elektrischen Energiequelle der weiteren elektrischen Energieversorgungseinheit stammen als auch aus einem öffentlichen elektrischen Versorgungsnetz, das beispielsweise mit der weiteren elektrischen Energieversorgungseinheit verbunden ist. Somit kann der erste Füllstand des ersten Energiespeichers der elektrischen Energieversorgungseinheit auch dann erhöht werden, wenn die elektrische Energieversorgungseinheit über keine eigene elektrische Energiequelle verfügt.

In einer weiteren Ausführungsform umfasst die elektrischen Energieversorgungseinheit zusätzlich einen Innenwiderstand, der so dimensioniert ist, dass die Wechselspannung bei Nennleistung der elektrischen Energieversorgungseinheit im Bereich von 90%-98% der Nennspannung, im Besonderen im Bereich von 90%-95% der Nennspannung, und im ganz Besonderen im Bereich von 90%-92% der Nennspannung liegt.

Dies ermöglicht eine passive Lastaufteilung zwischen mehreren elektrischen Energieversorgungseinheiten, die elektrisch leitend miteinander verbunden sind. Gleichzeitig werden die durch einschlägige Normen festgelegten Spannungsbereiche, wie beispielsweise Nennspannung ± 10%, eingehalten.

Der Innenwiderstand kann beispielsweise dadurch simuliert werden, dass ein Effektivwert der Wechselspannung in Abhängigkeit eines vom Wechselspannungserzeuger abgegebenen Stroms gesteuert wird. Dies hat den Vorteil, dass der Wirkungsgrad der elektrischen Energieversorgungseinheit sehr gut ist, obwohl der am zweiten Anschluss beobachtete Innenwiderstand relativ gross ist.

In einer weiteren Ausführungsform umfasst die elektrische Energieversorgungseinheit zusätzlich ein stapelbares Gehäuse.

Damit wird es besonders einfach und platzsparend, mehrere erfindungsgemässe elektrische Energieversorgungseinheiten an einem Ort zu installieren oder aufzustellen.

Im Besonderen weist das Gehäuse im Bereich einer Unterseite und/oder einer Oberseite eine Strukturierung auf, insbesondere wenigstens einen Vorsprung, eine Vertiefung und/oder eine Ausnehmung. Die Unterseite ist dabei insbesondere eine Standfläche des Gehäuses der Energieversorgungseinheit, welche insbesondere zur horizontalen Ausrichtung vorgesehen ist. Die Oberseite ist typischerweise eine zur Unterseite coplanare Seite des Gehäuses.

Solche Strukturierungen können einem Verrutschen des Gehäuses auf einem Bodenbereich entgegen wirken. Zudem kann dadurch eine sichere Stapelung von mehreren elektrischen Energieversorgungseinheiten erreicht werden.

Besonders bevorzugt liegt an der Unterseite des Gehäuses wenigstens eine Strukturierung vor und an der Oberseite liegt wenigstens eine weitere Strukturierung vor. Die wenigstens eine Strukturierung an der Unterseite ist dabei mit Vorteil komplementär zur wenigstens einen Strukturierung an der Oberseite ausgebildet. Dies insbesondere so, dass beim Stapeln von zwei elektrischen Energieversorgungseinheiten die wenigstens eine Strukturierung, z.B. ein Vorsprung, an der Oberseite des Gehäuses der elektrischen Energieversorgungseinheit in die wenigstens eine Strukturierung, z.B. eine Vertiefung, an der Unterseite des Gehäuses der weiteren elektrischen Energieversorgungseinheit eingreift.

Dadurch lassen sich elektrische Energieversorgungseinheiten in besonders definierter und stabiler Art und Weise stapeln.

Weiter betrifft die vorliegende Erfindung ein elektrisches Energieversorgungssystem umfassend eine erfindungsgemässe elektrische Energieversorgungseinheit und mindestens eine weitere erfindungsgemässe elektrische Energieversorgungseinheit, wobei die elektrische Energieversorgungseinheit und die weitere elektrische Energieversorgungseinheit elektrisch leitend miteinander verbunden sind. Im Besonderen ist die weitere elektrische Energieversorgungseinheit eine erfindungsgemässe elektrische Energieversorgungseinheit.

Mit einem erfindungsgemässen elektrischen Energieversorgungssystem kann ein beliebiges Inselsystem (Mikro-Grids) gebildet werden, ohne dass eine vorherige anwendungsspezifische Auslegung nötig wäre. Das aus dem erfindungsgemässen elektrischen Energieversorgungssystem gebildete Inselsystem kann mit den Anforderungen wachsen, d.h. unnötig hohe Investitionskosten sind vermeidbar. Bei jeder Erweiterung mit erfindungsgemässen elektrischen Energieversorgungseinheiten sind alle bisherigen elektrischen Energieversorgungseinheiten weiterhin nutzbar. Dabei kann jede Erweiterung an einem beliebigen Ort erfolgen und dezentral erfolgen. Es ist auch möglich, zunächst getrennt arbeitende Inselsysteme zu einem beliebigen späteren Zeitpunkt miteinander zu verbinden und somit zu einem grösseren Inselsystem zusammen zu schliessen. Ein Inselsystem, beziehungsweise ein erfindungsgemässes elektrisches Energieversorgungssystem ist also in jeder Hinsicht höchst flexibel und kosteneffizient. Ferner führt der Ausfall einer elektrischen Energieversorgungseinheit des elektrischen Energieversorgungssystems nicht zum Ausfall des gesamten elektrischen Energieversorgungssystems, womit eine ausserordentlich hohe Zuverlässigkeit und Verfügbarkeit erreicht wird.

Die elektrischen Energieversorgungseinheiten eines elektrischen Energieversorgungssystems können über die zweiten Anschlüsse der Wechselspannungserzeuger der elektrischen Energieversorgungseinheiten elektrisch leitend verbunden werden.

In einer weiteren Ausführungsform des elektrischen Energieversorgungssystems sind die elektrische Energieversorgungseinheit und die weitere elektrische Energieversorgungseinheit elektrisch parallel miteinander verbunden.

Damit wird die Installation eines erfindungsgemässen elektrischen Energieversorgungssystems besonders einfach.

Ebenfalls Gegenstand der Erfindung ist ein Verfahren zum Steuern einer erfindungsgemässen elektrischen Energieversorgungseinheit umfassend die Schritte: a) Ermitteln einer Soll-Wechselspannung unter Berücksichtigung eines ersten Füllstands eines ersten Energiespeichers der elektrischen Energieversorgungseinheit und/oder eines weiteren Füllstands eines weiteren Energiespeichers einer weiteren elektrischen Energieversorgungseinheit, und b) Übertragen der Soll-Wechselspannung an einen Wechselspannungserzeuger der elektrischen Energieversorgungseinheit.

Die Steuerung sowie die elektrische Energieversorgungseinheit sind dabei insbesondere wie vorstehend beschrieben definiert. Insbesondere werden beim erfindungsgemässen Verfahren die im Zusammenhang mit der Steuerung und der Funktionsweise der elektrischen Energieversorgungseinheit beschriebenen Verfahrensschritte und/oder Funktionen durchgeführt.

Mit dem erfindungsgemässen Verfahren zum Steuern einer elektrischen Energieversorgungseinheit ist es möglich, eine Vielzahl von elektrischen Energieversorgungseinheiten ohne eine zentrale Steuerung zu steuern.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung der Ausführungsbeispiele verwendeten Zeichnungen zeigen:
- Fig. 1: eine erfindungsgemässe Steuerung,
- Fig. 2: eine Abhängigkeit der Soll-Frequenz vom ersten Füllstand,
- Fig. 3: eine Abhängigkeit der Soll-Frequenz vom Leistungsüberschuss,
- Fig. 4: eine Abhängigkeit des Soll-Effektivwerts von der Füllstandsdifferenz,
- Fig. 5: eine erweiterte Steuerung,
- Fig. 6: eine erfindungsgemässe elektrische Energieversorgungseinheit,
- Fig. 7: eine erste erweiterte elektrische Energieversorgungseinheit,
- Fig. 8: eine zweite erweiterte elektrische Energieversorgungseinheit,
- Fig. 9: einen Wechselspannungserzeuger aufweisend einen Hochsetzsteller und einen Wechselrichter mit Transformator,
- Fig. 10: ein elektrisches Energieversorgungssystem,
- Fig. 11: ein Gehäuse der elektrischen Energieversorgungseinheit.

Grundsätzlich sind in den Figuren gleiche Teile mit gleichen Bezugszeichen versehen.

### Wege zur Ausführung der Erfindung

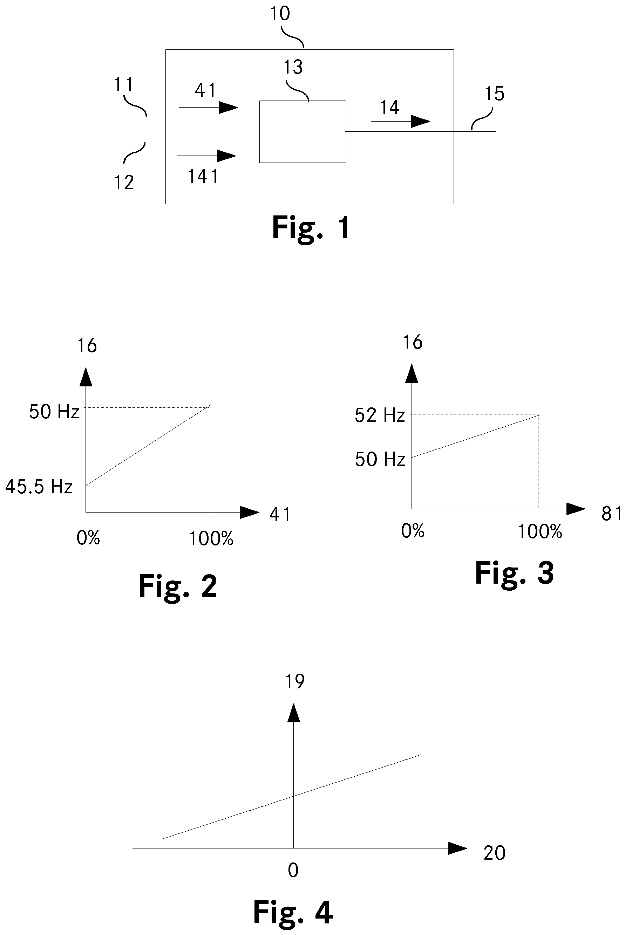

**Fig. 1** zeigt eine erfindungsgemässe Steuerung 10 für eine elektrische Energieversorgungseinheit. Im Betrieb ist die Steuerung 10 mit der elektrischen Energieversorgungseinheit durch eine Signalverbindung verbunden, so dass Betriebsdaten von der Steuerung 10 an die elektrischen Energieversorgungseinheit übertragen werden können und umgekehrt. Die Signalverbindung der Steuerung 10 mit der elektrischen Energieversorgungseinheit ist nicht dafür vorgesehen, elektrische Energie in einem Masse zu übertragen, das über die Erfordernisse einer Datensignalübertragung hinausgeht. Die Signalverbindung der Steuerung 10 mit der elektrischen Energieversorgungseinheit kann in Form von Signalleitungen erfolgen, oder optisch, oder per Funk. Die Steuerung 10 weist einen ersten Füllstandseingang 11 auf, an den im Betrieb ein erster Füllstand 41 eines ersten Energiespeichers der elektrischen Energieversorgungseinheit übertragen wird. An einen weiteren Füllstandseingang 12 der Steuerung 10 wird ein weiterer Füllstand 141 eines optionalen weiteren Energiespeichers einer weiteren elektrischen Energieversorgungseinheit übertragen. Des Weiteren weist die Steuerung 10 einen Soll-Wechselspannungsermittler 13 mit einem Soll-Wechselspannungsausgang 15 auf. Beide Eingänge der Steuerung 10, der erste Füllstandseingang 11 und der weitere Füllstandseingang 12, sind mit dem Soll-Wechselspannungsermittler 13 verbunden. Der Soll-Wechselspannungsausgang 15 ist im Betrieb mit einem Wechselspannungserzeuger der elektrischen Energieversorgungseinheit verbunden, so dass eine vom Soll-Wechselspannungsermittler 13 ermittelte Soll-Wechselspannung 14 an den Wechselspannungserzeuger übertragen wird. Der Soll-Wechselspannungsermittler 13 ermittelt die Soll-Wechselspannung 14 unter Berücksichtigung des ersten Füllstands 41 und/oder des weiteren Füllstands 141. Der Wechselspannungserzeuger erzeugt im Betrieb eine der Soll-Wechselspannung 14 entsprechende Wechselspannung, die beispielsweise einer mit der elektrischen Energieversorgungseinheit verbundenen Last zur Verfügung steht.

**Fig. 2** zeigt eine Ausführungsform in einem Betriebszustand, in welchem der Soll-Wechselspannungsermittler 13 eine Soll-Frequenz 16 der Soll-Wechselspannung 14 in Abhängigkeit des ersten Füllstands 41 ermittelt. Fig. 2 zeigt beispielhaft Werte für eine Nennfrequenz von 50Hz. Bei einer Nennfrequenz von 60Hz (nicht gezeigt) sind die Werte des 50Hz-Beispiels zu extrapolieren, beispielsweise linear. Bei einer Nennfrequenz von 50Hz und einem ersten Füllstand von 0% ermittelt der Soll-Wechselspannungsermittler 13 eine Soll-Wechselspannung 14 mit einer Soll-Frequenz 16 von 45.5Hz. Bei einem ersten Füllstand 41 von 100% ermittelt der Soll-Wechselspannungsermittler 13 eine Soll-Wechselspannung 14 mit einer Soll-Frequenz 16 von 50Hz, was der Nennfrequenz entspricht. Die Soll-Frequenz 16 steigt stetig und linear mit dem ersten Füllstand 41.

**Fig. 3** zeigt eine Ausführungsform in einem Betriebszustand, in welchem der Soll-Wechselspannungsermittler 13 bei einem Füllstand von 100% die Soll-Frequenz 16 der Soll-Wechselspannung 14 in Abhängigkeit eines Leistungsüberschusses 81 ermittelt. Fig. 3 zeigt beispielhaft Werte für eine Nennfrequenz von 50Hz. Bei einer Nennfrequenz von 60Hz (nicht gezeigt) sind die Werte des 50Hz-Beispiels zu extrapolieren, beispielsweise linear. Bei einer Nennfrequenz von 50Hz und einem Leistungsüberschuss 81 von 0% ermittelt der Soll-Wechselspannungsermittler 13 eine Soll-Wechselspannung 14 mit einer Soll-Frequenz 16 von 50Hz, was wiederum der Nennfrequenz entspricht. Bei einem Leistungsüberschuss 81 von 100% ermittelt der Soll-Wechselspannungsermittler 13 eine Soll-Wechselspannung 14 mit einer Soll-Frequenz 16 von 52Hz. Die Soll-Frequenz 16 steigt stetig und linear mit dem Leistungsüberschuss 81.

Die in Fig. 2 gezeigte Abhängigkeit der Soll-Frequenz 16 vom ersten Füllstand 41, und die in Fig. 3 gezeigte Abhängigkeit der Soll-Frequenz 16 vom Leistungsüberschuss 81 (bei einem Füllstand von 100%) wird insbesondere dann vom Soll-Wechselspannungsermittler 13 verwendet, wenn die elektrische Energieversorgungseinheit mit der erfindungsgemässen Steuerung 10 im Betrieb nur an eine Last angeschlossen ist, aber nicht an eine weitere elektrische Energieversorgungseinheit und auch nicht an ein öffentliches elektrisches Versorgungsnetz. In diesem Betriebszustand wird ein Soll-Effektivwert der Soll-Wechselspannung 14 vom Soll-Wechselspannungsermittler 13 derart ermittelt, dass die von der elektrischen Energieversorgungseinheit abgegebene Leistung im Wesentlichen die an die elektrische Energieversorgungseinheit angeschlossene Last deckt.

Im Gegensatz zur Signalverbindung zwischen der Steuerung 10 und der elektrischen Energieversorgungseinheit handelt es sich bei der elektrisch leitenden Verbindung zwischen der elektrischen Energieversorgungseinheit und einer daran angeschlossenen Last um eine Energieverbindung, die dafür vorgesehen ist, elektrische Energie zu übertragen. Ebenso ist die Verbindung zwischen der elektrischen Energieversorgungseinheit und der weiteren elektrischen Energieversorgungseinheit, oder allgemein zwischen elektrischen Energieversorgungseinheiten, immer eine Energieverbindung. Eine Energieverbindung kann zusätzlich zur Energieübertragung auch zur Übertagung von Datensignalen verwendet werden.

Wenn zusätzlich eine weitere elektrische Energieversorgungseinheit vorliegt, ist es nicht zwingend, dass die beiden Energiespeicher der beiden elektrischen Energieversorgungseinheiten den gleichen Füllstand haben. Es kann sein, dass der erste Füllstand 41 des ersten Energiespeichers der elektrischen Energieversorgungseinheit verschieden ist vom weiteren Füllstand 141 des weiteren Energiespeichers der weiteren elektrischen Energieversorgungseinheit. Folglich kann es auch sein, dass die beiden Soll-Wechselspannungsermittler verschiedene Soll-Frequenzen für die beiden elektrischen Energieversorgungseinheiten ermitteln, beispielsweise ermittelt der Soll-Wechselspannungsermittler 13 der Steuerung 10 der elektrischen Energieversorgungseinheit eine Soll-Frequenz 16, die verschieden von einer weiteren Soll-Frequenz der weiteren elektrischen Energieversorgungseinheit ist. Wenn nun solche elektrische Energieversorgungseinheiten, die mit verschiedenen Soll-Frequenzen arbeiten, miteinander elektrisch leitend verbunden würden, beispielsweise in Form einer Parallelschaltung, käme es zu einem unerwünschten Betriebszustand. Um dies zu vermeiden, synchronisiert sich eine elektrische Energieversorgungseinheit auf die andere elektrische Energieversorgungseinheit. Beispielsweise ist die Steuerung 10 dazu ausgebildet, aus einer weiteren Frequenz einer weiteren Wechselspannung eines weiteren Wechselspannungserzeugers der weiteren elektrischen Energieversorgungseinheit den weiteren Füllstand des weiteren Energiespeichers zu ermitteln. Dabei ist die Steuerung 10 der elektrischen Energieversorgungseinheit mit der weiteren Wechselspannung des weiteren Wechselspannungserzeugers der weiteren elektrischen Energieversorgungseinheit über eine Signalverbindung verbunden. Die Wechselspannung des Wechselspannungserzeugers der elektrischen Energieversorgungseinheit ist zu diesem Zeitpunkt aber noch nicht mit der weiteren Wechselspannung des weiteren Wechselspannungserzeugers der weiteren elektrischen Energieversorgungseinheit über eine Energieverbindung verbunden, so dass der unerwünschte Betriebszustand vermieden wird. Nun ermittelt der Soll-Wechselspannungsermittler 13 die Soll-Frequenz 16 in Abhängigkeit des weiteren Füllstands 141. Die elektrische Energieversorgungseinheit erzeugt folglich nun eine Wechselspannung mit einer Frequenz, die im Wesentlichen mit der weiteren Frequenz der weiteren Wechselspannung der weiteren elektrischen Energieversorgungseinheit übereinstimmt. Nun können auch die beiden Wechselspannungen der beiden Wechselspannungserzeuger über eine Energieverbindung elektrisch leitend miteinander verbunden werden, beispielsweise in Form einer Parallelschaltung, ohne dass der unerwünschte Betriebszustand auftritt.

Die erfindungsgemässe Steuerung 10 stellt jederzeit sicher, dass die Nulldurchgänge von Wechselspannungen mit gleicher Frequenz gleichzeitig erfolgen.

**Fig. 4** zeigt eine Ausführungsform in einem Betriebszustand, in welchem ein Soll-Effektivwert 19 der Soll-Wechselspannung 14 in Abhängigkeit von der Füllstandsdifferenz 20 ermittelt wird, wobei sich die Füllstandsdifferenz 20 aus dem ersten Füllstand 41 minus den weiteren Füllstand 141 berechnet. Dieser Betriebszustand kann auftreten, wenn die elektrische Energieversorgungseinheit mit einer weiteren elektrischen Energieversorgungseinheit über eine Energieverbindung elektrisch leitend verbunden ist, beispielsweise in Form einer Parallelschaltung der elektrischen Energieversorgungseinheit mit der weiteren elektrischen Energieversorgungseinheit. In dem Sonderfall, wo die Füllstandsdifferenz 20 gleich Null ist (Schnittpunkt der Achsen in Fig. 4), wird der Soll-Effektivwert 19 der Soll-Wechselspannung derart ermittelt, wie oben schon erwähnt, dass die von jeder elektrischen Energieversorgungseinheit abgegebene Leistung im Wesentlichen die an die jeweilige elektrische Energieversorgungseinheit angeschlossene Last deckt. Nimmt die Füllstandsdifferenz 20 einen positiven Wert an, d.h. der erste Füllstand 41 ist grösser als der weitere Füllstand 141, wird der Soll-Effektivwert 19 der Soll-Wechselspannung der elektrischen Energieversorgungseinheit erhöht (rechte Hälfte von Fig. 4) und, solange sich die Lasten nicht ändern, wird der weitere Soll-Effektivwert der weiteren Soll-Wechselspannung der weiteren elektrischen Energieversorgungseinheit entsprechend reduziert (siehe linke Hälfte der Fig. 4). Folglich wird die elektrische Energieversorgungseinheit mit dem grösseren Füllstand zusätzlich belastet und die elektrische Energieversorgungseinheit mit dem kleineren Füllstand wird entlastet. Die elektrischen Energieversorgungseinheiten verhalten sich sozusagen solidarisch. Das führt zu einem beschleunigten Abnehmen des ersten (grösseren) Füllstands 41, während der weitere (kleinere) Füllstand 141 weniger schnell abnimmt, oder gar nicht abnimmt, oder sogar zunimmt, bis beide Füllstände gleich sind. Die Füllstandsdifferenz nimmt mit der Zeit also ab, bis sie schliesslich gleich Null wird. Dabei verhält sich die weitere Steuerung der weiteren Energieversorgungseinheit, als wäre sie nur an eine Last angeschlossen, aber nicht an eine weitere Energieversorgungseinheit und ändert ihre weitere Soll-Frequenz gemäss ihres weiteren Füllstands 141. Das hat zur Folge, dass sich mit der Zeit nicht nur die Füllstände, d.h. der erste Füllstand 41 und der weitere Füllstand 141 angleichen, sondern auch die Soll-Frequenzen, d.h. die erste Soll-Frequenz 16 und die weitere Soll-Frequenz.

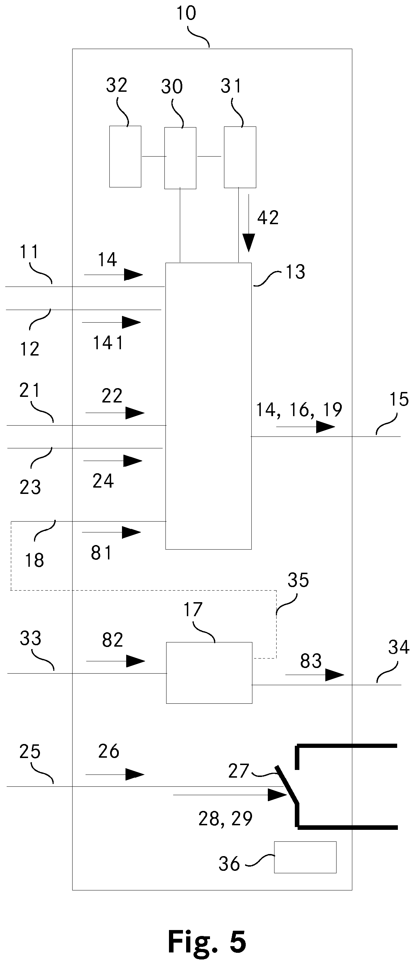

**Fig. 5** zeigt eine Ausführungsform der erfindungsgemässen Steuerung 10 mit einem Maximalleistungsregler 17. Von einer elektrischen Energiequelle der elektrischen Energieversorgungseinheit wird im Betrieb eine Ist-Quellenleistung 82 über einen die Steuerung 10 umfassenden Ist-Quellenleistungseingang 33 an den Maximalleistungsregler 17 übertragen. Der Maximalleistungsregler 17 variiert die Soll-Quellenleistung 83 an einem die Steuerung 10 umfassenden Soll-Quellenleistungsausgang 34 derart, dass die von der Energiequelle abgegebene Quellenleistung maximal wird. Je nach elektrischer Energiequelle kann der Soll-Quellenleistungsausgang 34 des Maximalleistungsreglers 17 mit einem Spannungswandler der elektrischen Energieversorgungseinheit über eine Signalverbindung verbunden sein, so dass der Spannungswandler die für eine maximale Quellenleistung der elektrischen Energiequelle erforderlichen Spannungen und Ströme einstellt.

Des Weiteren zeigt Fig. 5 eine Ausführungsform der Steuerung 10 mit einem Leistungsüberschusseingang 18, der mit dem Soll-Wechselspannungserzeuger 13 über eine Signalverbindung verbunden ist, so dass der Leistungsüberschuss 81 an den Soll-Wechselspannungserzeuger 13 übertragen werden kann.

In einer besonderen Ausführungsform kann der Leistungsüberschuss 81 vom Maximalleistungsregler 17 ermittelt werden und vom Maximalleistungsregler 17 an den Soll-Wechselspannungserzeuger 13 übertragen werden, was durch die gestrichelte Leistungsüberschusssignalverbindung 35 dargestellt ist. Ein Leistungsüberschuss kann dann entstehen, wenn der Maximalleistungsregler 17 die Soll-Quellenleistung am Soll-Quellenleistungsausgang 34 derart regelt, dass die von der Energiequelle abgegebene Quellenleistung nicht der maximal möglichen Leistung entspricht, sondern einer kleineren.

Ferner zeigt Fig. 5 eine Ausführungsform der Steuerung 10 mit einem Lastleistungseingang 21, der mit dem Soll-Wechselspannungserzeuger 13 verbunden ist, so dass die Lastleistung 22 an den Soll-Wechselspannungserzeuger 13 übertragen werden kann. Zudem hat die Steuerung 10 einem Erzeugerleistungseingang 23, der mit dem Soll-Wechselspannungserzeuger 13 verbunden ist, so dass die Erzeugerleistung 24 an den Soll-Wechselspannungserzeuger 13 übertragen werden kann.

Ausserdem zeigt Fig. 5 eine Ausführungsform der Steuerung 10, bei der am Soll-Wechselspannungsausgang 15 eine Soll Wechselspannung 14 zur Verfügung steht, die eine Soll-Frequenz 16 und einen Soll-Effektivwert 19 aufweist.

Des Weiteren zeigt Fig. 5 eine Ausführungsform der Steuerung 10 mit einem Austauschleistungseingang 25, der mit einem Schutzschalter 27 (in geöffnetem Zustand gezeichnet) über eine Signalverbindung verbunden ist, so dass die Austauschleistung 26 an den Schutzschalter 27 übertragen werden kann. Ebenso kann ein erster vorbestimmter Füllstandsschwellwert 28 und ein zweiter vorbestimmter Füllstandsschwellwert 29 an den Schutzschalter 27 übertragen werden. Der Schutzschalter 27 kann eine Energieverbindung (dick dargestellt) zwischen der elektrischen Energieversorgungseinheit und der weiteren elektrischen Energieversorgungseinheit herstellen (eingeschalter Zustand, nicht gezeigt). Falls die elektrische Energieversorgungseinheit bei geschlossenem Schutzschalter 27 von der weiteren elektrischen Energieversorgungseinheit eine elektrische Austauschleistung 26 bezieht und der erste Füllstand 41 trotzdem sinkt und einen ersten vorbestimmten Füllstandsschwellwert 28 erreicht oder unterschreitet, wird von einer fehlerhaften Last an der elektrischen Energieversorgungseinheit ausgegangen, und der Schutzschalter 27 öffnet sich. D.h. die elektrische Energieversorgungseinheit opfert sich, um die weitere elektrische Energieversorgungseinheit nicht unnötig weiter zu belasten. Falls die elektrische Energieversorgungseinheit bei geschlossenem Schutzschalter 27 an die weitere elektrische Energieversorgungseinheit eine elektrische Austauschleistung 26 liefert und der erste Füllstand 41 sinkt und einen zweiten vorbestimmten Füllstandsschwellwert 29 erreicht oder unterschreitet, wird von einer fehlerhaften Last an der weiteren elektrischen Energieversorgungseinheit ausgegangen, und der Schutzschalter 27 öffnet sich. D.h. die elektrische Energieversorgungseinheit schützt sich, um von der weiteren elektrischen Energieversorgungseinheit nicht unnötig weiter belastet zu werden.

In einer weiteren Ausführungsform kann zuvor beschriebener Fehlerzustand, wie in Fig. 5 gezeigt, von einer Anzeige 36 dadurch dargestellt werden, dass die Anzeige 36 ein optisches und/oder akustisches Warnsignal erzeugt, beispielsweise durch ein blinkendes Leuchtmittel, wie insbesondere eine LED, oder durch eine Farbveränderung eines Leuchtmittels von grün auf gelb oder rot, und/oder durch ein akustisches Signal wie beispielsweise ein Piep-Ton.

Sobald der Fehlerzustand durch einen Benutzer behoben wurde, kann der Benutzer das durch Quittieren an die Steuerung 10 mitteilen, so dass der Schalter 27 sich wieder einschalten kann.

Ferner zeigt Fig. 5 Ausführungsformen der Steuerung 10 mit einem Datenspeicher 30, einer Prognoseeinheit 31 und/oder einer Übermittlungseinheit 32. Bei dem Datenspeicher 30, der Prognoseeinheit 31 und/oder der Übermittlungseinheit 32 kann es sich um konventionelle Vorrichtungen handeln. Der Datenspeicher ist über eine Signalverbindung unter anderem mit dem Soll-Wechselspannungsermittler 13 verbunden, um Zugang zu Betriebsdaten zu haben und diese abspeichern zu können. Die Übermittlungseinheit 32 ist über eine Signalverbindung unter anderem mit dem Datenspeicher verbunden. Die Prognoseeinheit 31 ist über eine Signalverbindung unter anderem mit dem Datenspeicher verbunden und stellt dem Soll-Wechselspannungsermittler 13 den ersten zukünftigen Füllstand 42 zur Verfügung.

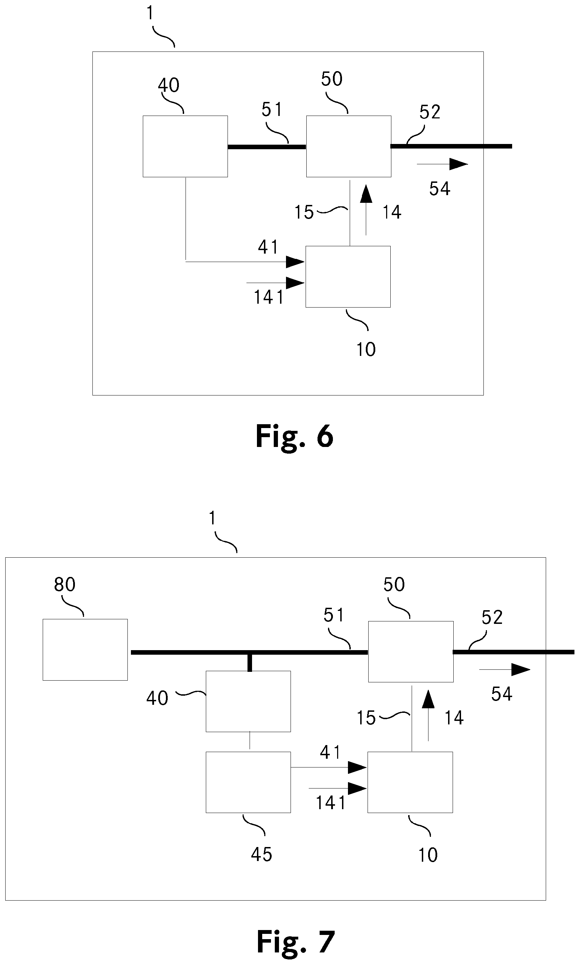

**Fig. 6** zeigt eine erfindungsgemässe elektrische Energieversorgungseinheit 1. Ein erster Energiespeicher 40, z.B. eine ventilgeregelte Bleibatterie vom Typ VRLA, ist über eine Energieverbindung (dick dargestellt) elektrisch leitend mit einem ersten Anschluss 51 eines Wechselspannungserzeugers 50 verbunden. Der Soll-Wechselspannungsausgang 15 der erfindungsgemässen Steuerung 10 ist über eine Signalverbindung (dünn dargestellt) mit dem Wechselspannungserzeuger 50 verbunden, der eine Wechselspannung 54 gemäss der Soll-Wechselspannung 14 am zweiten Anschluss 52 bereit stellt, an den über eine Energieverbindung (dick dargestellt) eine Last (nicht dargestellt) oder eine weitere Energieversorgungseinheit (nicht dargestellt) anschliessbar ist.

Der erste Energiespeicher 40 kann dazu ausgebildet sein, den ersten Füllstand 41 an die Steuerung 10 zu übertragen.

Der optionale weitere Füllstand 141 kann beispielsweise von der weiteren elektrischen Energieversorgungseinheit über die Übermittlungseinheit 32 (siehe Fig. 5) an den Soll-Wechselspannungsermittler 13 (siehe Fig. 5) der Steuerung 10 übertragen werden.

**Fig. 7** zeigt eine Ausführungsform der elektrischen Energieversorgungseinheit 1 mit einem Füllstandsermittler 45. Über eine Signalverbindung (dünn dargestellt) kann der Füllstandsermittler 45 Betriebsdaten vom Energiespeicher 40 beziehen und den ersten Füllstand 41 ermitteln, der dann an die Steuerung 10 übertragen wird.

Zudem zeigt Fig. 7 eine Ausführungsform der elektrischen Energieversorgungseinheit mit einer elektrischen Energiequelle 80, z.B. ein photovoltaisches Solarpanel. Die elektrische Energiequelle 80 ist über eine Energieverbindung (dick dargestellt) mit dem ersten Energiespeicher 40 verbunden.

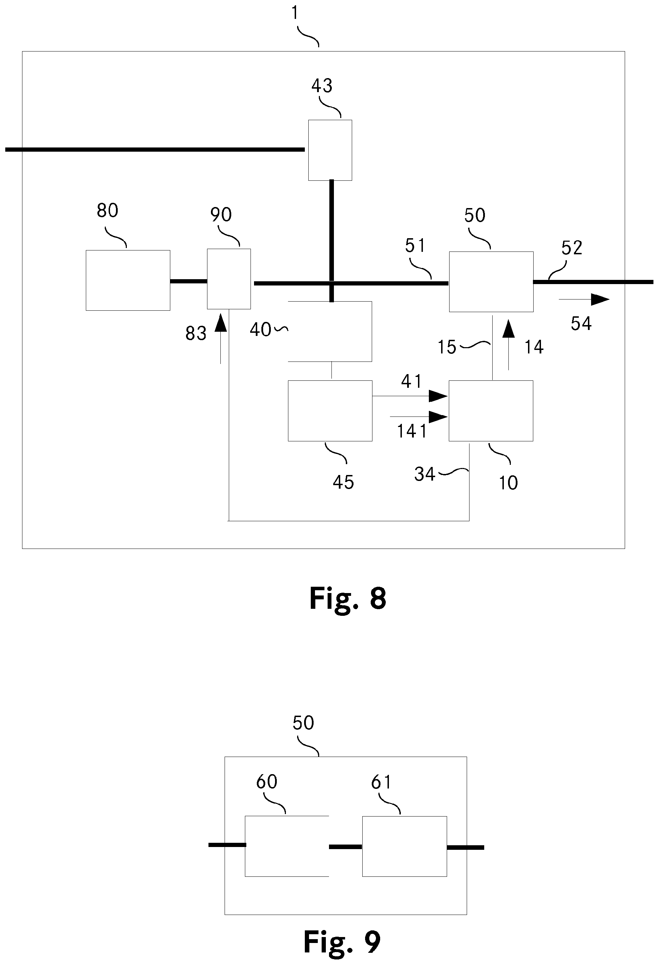

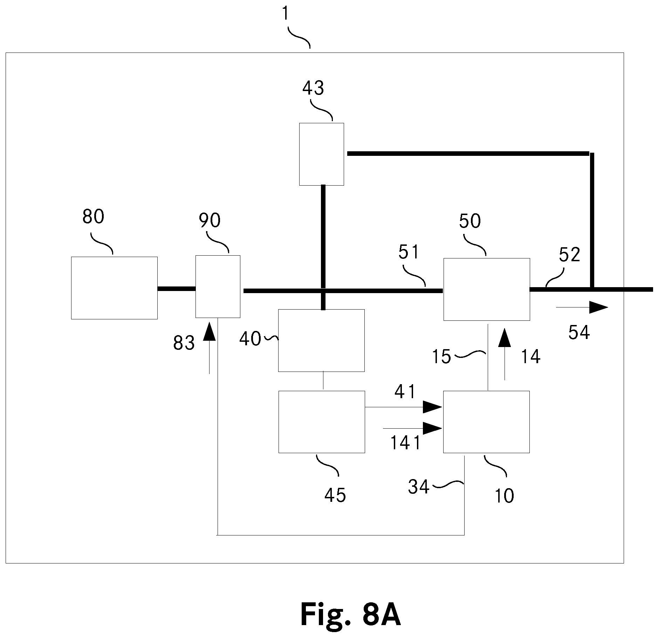

**Fig. 8** zeigt eine Ausführungsform der elektrischen Energieversorgungseinheit 1 mit einem Spannungswandler 90, der sich zwischen der Energiequelle und dem ersten Energiespeicher 40 befindet und über eine Signalverbindung mit dem Maximalleistungsregler 17 (siehe Fig. 5) der Steuerung 10 verbunden sein kann.

Zudem zeigt Fig. 8 eine Ausführungsform der elektrischen Energieversorgungseinheit mit einem Ladegerät 43, welches einerseits über eine Energieverbindung (dick dargestellt) mit dem ersten Energiespeicher 40 verbunden ist und andererseits über eine Energieverbindung (dick dargestellt) mit einem öffentlichen elektrischen Versorgungsnetz verbunden ist.

Die in **Fig. 8A** dargestellte Ausführungsform unterscheidet sich von der in Fig. 8 gezeigten Ausführungsform nur dadurch, dass die eingangsseitige Energieverbindung (dick dargestellt) des Ladegerätes 43 mit dem zweiten Anschluss 52 des Wechselspannungserzeugers 50 verbunden ist. Wenn zudem ein öffentliches elektrisches Versorgungsnetz mit dem zweiten Anschluss 52 verbunden ist, ist das Ladegerät 43 über den zweiten Anschluss auch mit dem öffentlichen elektrischen Versorgungsnetz verbunden.

**Fig. 9** zeigt eine Ausführungsform des Wechselspannungserzeugers aufweisend einen Hochsetzsteller und einen Wechselrichter mit Transformator.

Die Energieversorgungseinheit 1 ist beispielsweise vollständig in einem Gehäuse mit entsprechenden von aussen zugänglichen Steckverbindern, wie Steckdosen und Buchsen, untergebracht.

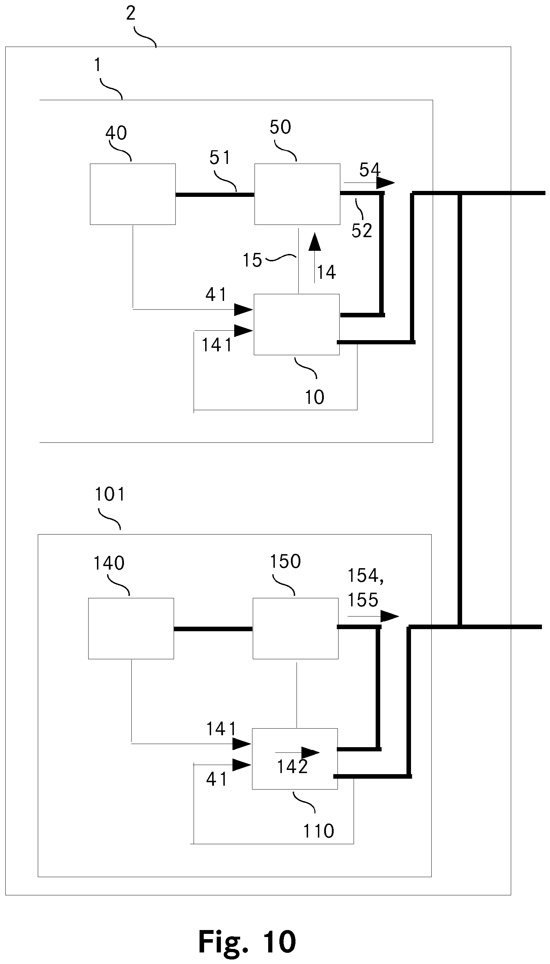

**Fig. 10** zeigt eine Ausführungsform des elektrischen Energieversorgungssystems 2 bestehend aus einer erfindungsgemässen elektrischen Energieversorgungseinheit 1 und einer erfindungsgemässen weiteren Energieversorgungseinheit 101. Beide Energieversorgungseinheiten 1, 101 sind über eine Energieverbindung elektrisch leitend verbunden, beispielsweise in Form einer Parallelschaltung. Eine weitere erfindungsgemässe Steuerung 110 der weiteren elektrischen Energieversorgungseinheit 101 kann identisch mit der Steuerung 10 sein, wie sie in Fig. 5 in unterschiedlichen Ausführungsformen gezeigt ist. Aus Platzgründen ist in Fig. 10 der weitere zukünftige Füllstand 142 der weiteren elektrischen Energieversorgungseinheit 101 in die weitere Steuerung 110 eingezeichnet ohne Darstellung des detaillierten Zusammenhangs, wie er in Fig. 5 gezeigt ist.

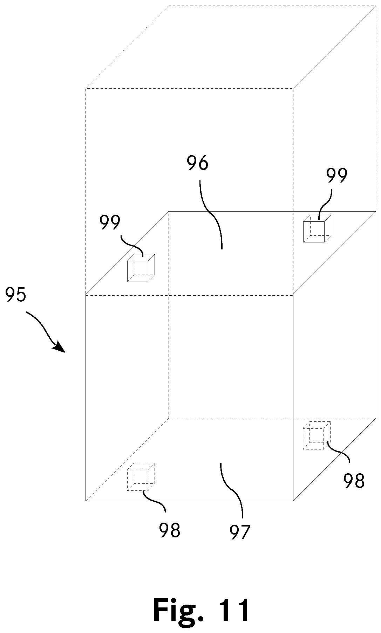

**Fig. 11** zeigt eine Ausführungsform eines stapelbaren quaderförmigen Gehäuses 95, in dem alle Komponenten der elektrischen Energieversorgungseinheit mit Ausnahme der elektrischen Energiequelle untergebracht sind. Im Besonderen weist das Gehäuse im Bereich einer Unterseite 97 zwei quaderförmige Vertiefungen 98 auf. Auf der Oberseite 96 befinden sich zu den Vertiefungen 98 komplementäre Vorsprünge 99. Das Gehäuse verfügt zudem über nicht gezeigte elektrische Anschlüsse in Form von Steckdosen und Buchsen.

Die vorstehend beschriebenen Ausführungsformen können im Rahmen der Erfindung beliebig abgewandelt werden.

Beispielsweise kann das Energieversorgungssystem 2 aus Fig. 10 auch mehr als zwei und/oder unterschiedliche elektrische Energieversorgungseinheiten aufweisen. Auch kann der erste Energiespeicher 40 aus mehreren und allenfalls auch unterschiedlichen Energiespeichern bestehen. Beispielsweise kann als Energiespeicher ein Akkumulator und eine Brennstoffzelle kombiniert werden.

Auch denkbar ist es, anstelle einer einzelnen elektrischen Energiequelle 80 mehrere und allenfalls unterschiedliche Energiequellen vorzusehen. So kann beispielsweise ein photovoltaisches Solarpanel mit einer Windturbine kombiniert werden, um die Abhängigkeit der Energieproduktion vom Wetter unabhängiger zu machen.

Zusammenfassend ist festzustellen, dass die erfindungsgemässe Steuerung eine besonders vorteilhafte und zweckmässige Steuerung von elektrischen Energieversorgungseinheiten ermöglicht. Energieversorgungseinheiten mit derartigen Steuerungen können in einfaeher Art und Weise und flexibel miteinander kombiniert werden. Dies ohne dass aufwändige Installations- oder Kalibrationsarbeiten notwendig sind. Dies ermöglicht eine einfache und sichere Versorgung mit elektrischer Energie, die unabhängig von einem öffentlichen elektrischen Versorgungsnetz zur Verfügung steht und flexibel an sich verändernde Bedürfnisse angepasst werden kann.

## Patentansprüche

1. Steuerung (10) für eine elektrische Energieversorgungseinheit (1), umfassend:
a) einen ersten Füllstandseingang (11), an den ein erster Füllstand (41) eines ersten Energiespeichers (40) der elektrischen Energieversorgungseinheit (1) übertragbar ist,
b) einen weiteren Füllstandseingang (12), an den ein weiterer Füllstand (141) eines optionalen weiteren Energiespeichers (140) einer weiteren elektrischen Energieversorgungseinheit (101) übertragbar ist,
c) einen Soll-Wechselspannungsermittler (13), der dazu ausgebildet ist, eine Soll-Wechselspannung (14) unter Berücksichtigung des ersten Füllstands (41) und/oder des weiteren Füllstands (141) zu ermitteln, wobei
1) der Soll-Wechselspannungsermittler (13) dazu ausgebildet ist, eine Soll-Frequenz (16) der Soll-Wechselspannung (14) unter Berücksichtigung des ersten Füllstands (41) und/oder des weiteren Füllstands (141) zu ermitteln, und/oder
2) die Steuerung (10) dazu ausgebildet ist, aus einer weiteren Frequenz (155) einer weiteren Wechselspannung (154) eines weiteren Wechselspannungserzeugers (150) der weiteren elektrischen Energieversorgungseinheit (101) den weiteren Füllstand (141) des weiteren Energiespeichers (140) zu ermitteln,
d) einen Soll-Wechselspannungsausgang (15), von dem die Soll-Wechselspannung (14) an einen Wechselspannungserzeuger (50) der elektrischen Energieversorgungseinheit (1) übertragbar ist
**dadurch gekennzeichnet, dass**
der Soll-Wechselspannungsermittler (13) so ausgebildet ist, dass die Soll-Frequenz (16)
e) im Wesentlichen der weiteren Frequenz (155) entspricht, wenn die weitere elektrische Energieversorgungseinheit (101) elektrisch leitend mit der elektrischen Energieversorgungseinheit (1) verbunden ist, und
f) andernfalls unter Berücksichtigung des ersten Füllstands (41) ermittelt wird

2. Steuerung (10) für eine elektrische Energieversorgungseinheit (1) nach Anspruch 1, wobei der Soll-Wechselspannungsermittler (13) so ausgebildet ist, dass die Soll-Frequenz (16)
a) im Wesentlichen der weiteren Frequenz (155) entspricht, wenn die weitere elektrische Energieversorgungseinheit (101) elektrisch leitend mit der elektrischen Energieversorgungseinheit (1) verbunden ist und wenn der weitere Füllstand (141) grösser als der Füllstand (41) ist, und
b) andernfalls im Wesentlichen unter Berücksichtigung des ersten Füllstands (41) ermittelt wird.

3. Steuerung (10) für eine elektrische Energieversorgungseinheit (1) nach einem der Ansprüche 1-2, wobei der Soll-Wechselspannungsermittler (13) den ersten Füllstand (41) derart berücksichtigt, dass die Soll-Frequenz (16) stetig mit dem ersten Füllstand (41) steigt.

4. Steuerung (10) für eine elektrische Energieversorgungseinheit (1) nach einem der Ansprüche 1-3, zusätzlich umfassend:
a) einen Leistungsüberschusseingang (18), an den ein Leistungsüberschuss (81) einer elektrischen Energiequelle (80) übertragbar ist,
wobei der Soll-Wechselspannungsermittler (13) zusätzlich dazu ausgebildet ist, bei einem ersten Füllstand (41) von 100% die Soll-Frequenz (16) in Abhängigkeit des Leistungsüberschusses (81) zu ermitteln.

5. Steuerung (10) für eine elektrische Energieversorgungseinheit (1) nach Anspruch 4, wobei der Soll-Wechselspannungsermittler (13) den ersten Füllstand (41) derart berücksichtigt, dass die Soll-Frequenz (16) stetig mit dem Leistungsüberschuss (81) steigt.

6. Steuerung (10) für eine elektrische Energieversorgungseinheit (1) nach einem der Ansprüche 1-5, wobei der Soll-Wechselspannungsermittler (13) zusätzlich dazu ausgebildet ist, einen Soll-Effektivwert (19) der Soll-Wechselspannung (14) in Abhängigkeit von einer Füllstandsdifferenz (20) zu ermitteln, wobei sich die Füllstandsdifferenz berechnet aus dem ersten Füllstand minus den weiteren Füllstand.

7. Steuerung (10) für eine elektrische Energieversorgungseinheit (1) nach Anspruch 6, wobei der Soll-Wechselspannungsermittler (13) zusätzlich dazu ausgebildet ist, den Soll-Effektivwert (19) der Soll-Wechselspannung (14) so zu regeln, dass die Füllstandsdifferenz (20) im stationären Zustand gegen Null konvergiert.

8. Steuerung (10) für eine elektrische Energieversorgungseinheit (1) nach einem der Ansprüche 6-7, wobei der Soll-Wechselspannungsermittler (13) zusätzlich dazu ausgebildet ist, den Soll-Effektivwert (19) der Soll-Wechselspannung (14) in Abhängigkeit von einem vom Wechselspannungserzeuger (50) abgegebenen Strom zu ermitteln.

9. Steuerung (10) für eine elektrische Energieversorgungseinheit (1) nach einem der Ansprüche 1-8, wobei der Soll-Wechselspannungsermittler (13) zusätzlich dazu ausgebildet ist, die Soll-Wechselspannung (14) für zumindest eine Sollwechselspannungsperiode auf Null zu setzen, wenn innerhalb des Wechselspannungserzeugers (50) eine Überspannung auftritt.

10. Steuerung (10) für eine elektrische Energieversorgungseinheit (1) nach einem der Ansprüche 1-9, zusätzlich umfassend:
a) einen Lastleistungseingang (21), an den eine Lastleistung (22) einer an die elektrische Energieversorgungseinheit (1) angeschlossenen Last übertragbar ist, und insbesondere
b) einen Erzeugerleistungseingang (23), an den eine von dem Wechselspannungserzeuger (50) der elektrischen Energieversorgungseinheit (1) abgegebene Erzeugerleistung (24) übertragbar ist,
wobei der Soll-Wechselspannungsermittler (13) zusätzlich dazu ausgebildet ist, den Soll-Effektivwert (19) so zu ermitteln, dass:
c) die Erzeugerleistung (24) grösser als die Lastleistung (22) ist, wenn der erste Füllstand (41) grösser als der weitere Füllstand (141) ist,
d) die Erzeugerleistung (24) kleiner als die Lastleistung (22) ist, wenn der erste Füllstand (41) kleiner als der weitere Füllstand (141) ist,
e) die Erzeugerleistung (24) gleich der Lastleistung (22) ist, wenn der erste Füllstand (41) dem weiteren Füllstand (141) entspricht

11. Steuerung (10) für eine elektrische Energieversorgungseinheit (1) nach einem der Ansprüche 1-10, zusätzlich umfassend:
a) einen Austauschleistungseingang (25), an den eine Austauschleistung (26), die von der elektrischen Energieversorgungseinheit (1) zu der weiteren elektrischen Energieversorgungseinheit (101) fliesst, übertragbar ist, und insbesondere
b) einen Schutzschalter (27), der dazu ausgebildet ist, eine elektrisch leitende Verbindung zwischen der elektrischen Energieversorgungseinheit (1) und der weiteren elektrischen Energieversorgungseinheit (101) herzustellen, und die elektrisch leitende Verbindung zu trennen, wenn:
i. die Austauschleistung (26) kleiner als Null ist und der erste Füllstand (41) gleich oder kleiner als ein erster vorbestimmter Füllstandsschwellwert (28) ist,
ii. die Austauschleistung (26) grösser als Null ist und der erste Füllstand (41) gleich oder kleiner als ein zweiter vorbestimmter Füllstandsschwellwert (29) ist.

12. Elektrische Energieversorgungseinheit (1), umfassend
a) eine Steuerung (10) nach einem der Ansprüche 1-11,
b) einen ersten Energiespeicher (40);
c) einen Wechselspannungserzeuger (50) mit einem ersten Anschluss (51) und einem zweiten Anschluss (52), wobei der erste Anschluss (52) elektrisch leitend mit dem ersten Energiespeicher (40) verbunden ist, und wobei der Wechselspannungserzeuger (50) dazu ausgebildet ist, eine einer Soll-Wechselspannung (14) entsprechende Wechselspannung (54) am zweiten Anschluss (52) zu erzeugen.

13. Elektrische Energieversorgungseinheit (1) nach Anspruch 12, zusätzlich umfassend einen Füllstandsermittler (45) zum Ermitteln eines ersten Füllstands (41) des ersten Energiespeichers (40), und/oder eine elektrische Energiequelle (80), die mit dem ersten Energiespeicher (40) elektrisch leitend verbindbar ist, und/oder einen Spannungswandler (90), der eingangsseitig mit der elektrischen Energiequelle (80) und ausgangsseitig mit dem ersten Energiespeicher (40) elektrisch verbunden ist, und/oder ein Ladegerät (43), welches eingangsseitig mit einem elektrischen Versorgungsnetz verbindbar ist und ausgangsseitig mit dem ersten Energiespeicher (40) verbunden ist.

14. Elektrisches Energieversorgungssystem (2), umfassend eine elektrische Energieversorgungseinheit (1) nach einem der Ansprüche 12-13 und mindestens eine weitere elektrische Energieversorgungseinheit (101), wobei die elektrische Energieversorgungseinheit (1) und die weitere elektrische Energieversorgungseinheit (101) elektrisch leitend miteinander verbunden sind, wobei im Besonderen die weitere elektrische Energieversorgungseinheit (101) eine elektrische Energieversorgungseinheit nach einem der Ansprüche 12-13 ist.

15. Verfahren zum Steuern einer elektrischen Energieversorgungseinheit (1) nach einem der Ansprüche 12-13, umfassend die Schritte:
a) Ermitteln einer Soll-Wechselspannung (14) unter Berücksichtigung eines ersten Füllstands (41) eines ersten Energiespeichers (40) der elektrischen Energieversorgungseinheit (1) und/oder eines weiteren Füllstands (141) eines weiteren Energiespeichers (140) einer weiteren elektrischen Energieversorgungseinheit (101), wobei 1) eine Soll-Frequenz der Soll-Wechselspannung unter Berücksichtigung des ersten Füllstands und/oder des weiteren Füllstands ermittelt wird, und/oder 2) aus einer weiteren Frequenz einer weiteren Wechselspannung eines weiteren Wechselspannungserzeugers der weiteren elektrischen Energieversorgungseinheit der weitere Füllstand des weiteren Energiespeichers ermittelt wird,
b) Übertragen der Soll-Wechselspannung (14) an einen Wechselspannungserzeuger (50) der elektrischen Energieversorgungseinheit (1), wobei die Soll-Frequenz
e) im Wesentlichen der weiteren Frequenz entspricht, wenn die weitere elektrische Energieversorgungseinheit elektrisch leitend mit der elektrischen Energieversorgungseinheit verbunden ist, und
f) andernfalls unter Berücksichtigung des ersten Füllstands ermittelt wird.

## Claims

1. A controller (10) for an electrical energy supply unit (1), comprising:
a) a first filling level input (11), to which a first filling level (41) of a first energy store (40) of the electrical energy supply unit (1) is transmittable,
b) a further filling level input (12), to which a further filling level (141) of an optional further energy store (140) of a further electrical energy supply unit (101) is transmittable,
c) a nominal alternating voltage determiner (13), which is designed to determine a nominal alternating voltage (14) in consideration of the first filling level (41) and/or of the further filling level (141), wherein
1) the nominal alternating voltage determiner (13) is designed to determine a nominal frequency (16) of the nominal alternating voltage (14) in consideration of the first filling level (41) and/or of the further filling level (141), and/or
2) the controller (10) is designed, from a further frequency (155) of a further alternating voltage (154) on a further alternating voltage generator (150) of the further electrical energy supply unit (101), to determine the further filling level (141) of the further energy store (140),
d) a nominal alternating voltage output (15), from which the nominal alternating voltage (14) is transmittable to an alternating voltage generator (50) of the electrical energy supply unit (1)
**characterized in that** the nominal alternating voltage determiner (13) is configured such that the nominal frequency (16)
e) essentially corresponds to the further frequency (155), if the further electrical energy supply unit (101) is connected to the electrical energy supply unit (1) in an electrically conductive manner, and
f) is otherwise determined in consideration of the first filling level (41).

2. The controller (10) for an electrical energy supply unit (1) as claimed in claim 1, wherein the nominal alternating voltage determiner (13) is configured such that the nominal frequency (16)
a) essentially corresponds to the further frequency (155), if the further electrical energy supply unit (101) is connected to the electrical energy supply unit (1) in an electrically conductive manner and if the further filling level (141) exceeds the filling level (41), and
b) is otherwise essentially determined in consideration of the first filling level (41).

3. The controller (10) for an electrical energy supply unit (1) as claimed in one of claims 1-2, wherein the nominal alternating voltage determiner (13) can consider the first filling level (41), such that the nominal frequency (16) steadily rises with the first filling level (41).

4. The controller (10) for an electrical energy supply unit (1) as claimed in one of claims 1-3, additionally comprising:
a) an excess power input (18), to which the excess power (81) of an electrical energy source (80) is transmittable,
wherein the nominal alternating voltage determiner (13) is additionally configured, at a first filling level (41) of 100%, to determine the nominal frequency (16) in relation to the excess power (81).

5. The controller (10) for an electrical energy supply unit (1) as claimed in claim 4, wherein the nominal alternating voltage determiner (13) can consider the first filling level (41) such that the nominal frequency (16) steadily rises with the excess power (81).

6. The controller (10) for an electrical energy supply unit (1) as claimed in one of claims 1-5, wherein the nominal alternating voltage determiner (13) is additionally designed to determine a nominal effective value (19) of the nominal alternating voltage (14) in relation to a filling level differential (20), wherein the filling level differential is calculated by the deduction of the further filling level from the first filling level.

7. The controller (10) for an electrical energy supply unit (1) as claimed in claim 6, wherein the nominal alternating voltage determiner (13) is additionally designed to regulate the nominal effective value (19) of the nominal alternating voltage (14), such that the filling level differential (20), in the stationary state, converges towards zero.

8. The controller (10) for an electrical energy supply unit (1) as claimed in one of claims 6-7, wherein the nominal alternating voltage determiner (13) is additionally designed to determine the nominal effective value (19) of the nominal alternating voltage (14), in accordance with a current output from the alternating voltage generator (50).

9. The controller (10) for an electrical energy supply unit (1) as claimed in one of claims 1-8, wherein the nominal alternating voltage determiner (13) is additionally configured to set the nominal alternating voltage (14) for at least one nominal alternating voltage cycle to zero, if an overvoltage occurs within the alternating voltage generator (50).

10. The controller (10) for an electrical energy supply unit (1) as claimed in one of claims 1-9, additionally comprising:
a) a load power input (21), to which a load power (22) of a load which is connected to the electrical energy supply unit (1) is transmittable, and specifically
b) a generator power input (23), to which a generator power (24) delivered by the alternating voltage generator (50) of the electrical energy supply unit (1) is transmittable,
wherein the nominal alternating voltage determiner (13) is additionally configured to determine the nominal effective value (19) such that:
c) the generator power (24) is greater than the load power (22), if the first filling level (41) is greater than the further filling level (141),
d) the generator power (24) is smaller than the load power (22), if the first filling level (41) is smaller than the further filling level (141),
e) the generator power (24) is equal to the load power (22), if the first filling level (41) corresponds to the further filling level (141).

11. The controller (10) for an electrical energy supply unit (1) as claimed in one of claims 1-10, additionally comprising:
a) an interchange power input (25), to which an interchange power (26) which flows from the electrical energy supply unit (1) to the further electrical energy supply unit (101) is transmittable, and specifically
b) a circuit-breaker (27), which is designed to establish an electrically conductive connection between the electrical energy supply unit (1) and the further electrical energy supply unit (101), and to interrupt the electrically conductive connection, if:
i. the interchange power (26) is lower than zero and the first filling level (41) is equal to or lower than a first predefined filling level threshold value (28),
ii. the interchange power (26) is greater than zero and the first filling level (41) is equal to or lower than a second predefined filling level threshold value (29).

12. An electrical energy supply unit (1), comprising
a) a controller (10) as claimed in one of claims 1-11,
b) a first energy store (40);
c) an alternating voltage generator (50) having a first terminal (51) and a second terminal (52), wherein the first terminal (52) is connected to the first energy store (40) in an electrically conductive manner, and wherein the alternating voltage generator (50) is designed to generate an alternating voltage (54) which corresponds to a nominal alternating voltage (14) on the second terminal (52).

13. The electrical energy supply unit (1) as claimed in claim 12, additionally comprising a filling level detector (45) for determining a first filling level (41) of the first energy store (40), and/or an electrical energy source (80) which is connectable to the first energy store (40) in an electrically conductive manner, and/or a voltage converter (90), which is electrically connected on the input side to the electrical energy source (80), and on the output side to the first energy store (40), and/or charging device (43) which, on the input side, is connectable to an electricity supply network and, on the output side, is connected to the first energy store (40).

14. An electrical energy supply system (2) comprising an electrical energy supply unit (1) as claimed in one of claims 12-13 and at least one further electrical energy supply unit (101), wherein the electrical energy supply unit (1) and the further electrical energy supply unit (101) are mutually interconnected in an electrically conductive manner and wherein, specifically, the further electrical energy supply unit (101) is an electrical energy supply unit as claimed in one of claims 12-13.

15. A method for controlling an electrical energy supply unit (1) as claimed in one of claims 12-13, comprising the following steps:
a) determination of a nominal alternating voltage (14), in consideration of a first filling level (41) of a first energy store (40) of the electrical energy supply unit (1) and/or of a further filling level (141) of a further energy store (140) of a further electrical energy supply unit (101), wherein 1) a nominal frequency (16) of the nominal alternating voltage is determined in consideration of the first filling level and/or of the further filling level, and/or 2) from a further frequency of a further alternating voltage on a further alternating voltage generator of the further electrical energy supply unit, the further filling level of the further energy store is determined,
b) transmission of the nominal alternating voltage (14) to an alternating voltage generator (50) of the electrical energy supply unit (1), wherein the nominal alternating voltage
e) essentially corresponds to the further frequency , if the further electrical energy supply unit is connected to the electrical energy supply unit in an electrically conductive manner, and
f) is otherwise determined in consideration of the first filling level.

## Revendications

1. Commande (10) pour une unité d'alimentation en énergie électrique (1), comprenant :
a) une première entrée de niveau de remplissage (11) à laquelle peut être transmis un premier niveau de remplissage (41) d'un premier accumulateur d'énergie (40) de l'unité d'alimentation en énergie électrique (1),
b) une entrée de niveau de remplissage supplémentaire (12) à laquelle peut être transmis un niveau de remplissage supplémentaire (141) d'un accumulateur d'énergie supplémentaire (140) en option d'une unité d'alimentation en énergie électrique supplémentaire (101),
c) un détecteur de tension alternative de consigne (13) réalisé pour détecter une tension alternative de consigne (14) en tenant compte du premier niveau de remplissage (41) et/ou du niveau de remplissage supplémentaire (141),
1) le détecteur de tension alternative de consigne (13) étant réalisé pour détecter une fréquence de consigne (16) de la tension alternative de consigne (14) en tenant compte du premier niveau de remplissage (41) et/ou du niveau de remplissage supplémentaire (141) et/ou
2) la commande (10) étant réalisée pour détecter à partir d'une fréquence supplémentaire (155) d'une tension alternative supplémentaire (154) d'un générateur de tension alternative supplémentaire (150) de l'unité d'alimentation en énergie électrique supplémentaire (101) le niveau de remplissage supplémentaire (141) de l'accumulateur d'énergie supplémentaire (140),
d) une sortie de tension alternative de consigne (15) à partir de laquelle la tension alternative de consigne (14) peut être transmise à un générateur de tension alternative (50) de l'unité d'alimentation en énergie électrique (1),
**caractérisée en ce que** le détecteur de tension alternative de consigne (13) est réalisé de telle sorte que la fréquence de consigne (16)
e) correspond substantiellement à la fréquence supplémentaire (155) si l'unité d'alimentation en énergie électrique supplémentaire (101) est connectée de manière électriquement conductrice à l'unité d'alimentation en énergie électrique (1), et
f) sinon, est détectée en tenant compte du premier niveau de remplissage (41).

2. Commande (10) pour une unité d'alimentation en énergie électrique (1) selon la revendication 1, dans laquelle le détecteur de tension alternative de consigne (13) est réalisé de telle sorte que la fréquence de consigne (16)
a) correspond substantiellement à la fréquence supplémentaire (155) si l'unité d'alimentation en énergie électrique supplémentaire (101) est connectée de manière électriquement conductrice à l'unité d'alimentation en énergie électrique (1) et si le niveau de remplissage supplémentaire (141) est supérieur au niveau de remplissage (41), et
b) sinon, est détectée substantiellement en tenant compte du premier niveau de remplissage (41).

3. Commande (10) pour une unité d'alimentation en énergie électrique (1) selon l'une quelconque des revendications 1 et 2, dans laquelle le détecteur de tension alternative de consigne (13) tient compte du premier niveau de remplissage (41) de telle sorte que la fréquence de consigne (16) augmente constamment avec le premier niveau de remplissage (41).

4. Commande (10) pour une unité d'alimentation en énergie électrique (1) selon l'une quelconque des revendications 1 à 3, comprenant en outre :
a) une entrée de surplus de puissance (18) à laquelle peut être transmis un surplus de puissance (81) d'une source d'énergie électrique (80),
dans laquelle le détecteur de tension alternative de consigne (13) est en outre réalisé, pour un premier niveau de remplissage (41) de 100 %, pour détecter la fréquence de consigne (16) en fonction du surplus de puissance (81).

5. Commande (10) pour une unité d'alimentation en énergie électrique (1) selon la revendication 4, dans laquelle le détecteur de tension alternative de consigne (13) tient compte du premier niveau de remplissage (41) de telle sorte que la fréquence de consigne (16) augmente constamment avec le surplus de puissance (81).

6. Commande (10) pour une unité d'alimentation en énergie électrique (1) selon l'une quelconque des revendications 1 à 5, dans laquelle le détecteur de tension alternative de consigne (13) est en outre réalisé pour détecter une valeur effective de consigne (19) de la tension alternative de consigne (14) en fonction d'une différence de niveau de remplissage (20), la différence de niveau de remplissage étant calculée par le premier niveau de remplissage moins le niveau de remplissage supplémentaire.

7. Commande (10) pour une unité d'alimentation en énergie électrique (1) selon la revendication 6, dans laquelle le détecteur de tension alternative de consigne (13) est en outre réalisé pour régler la valeur effective de consigne (19) de la tension alternative de consigne (14) de telle sorte que la différence de niveau de remplissage (20) converge vers zéro à l'état stationnaire.

8. Commande (10) pour une unité d'alimentation en énergie électrique (1) selon l'une quelconque des revendications 6 et 7, dans laquelle le détecteur de tension alternative de consigne (13) est en outre réalisé pour détecter la valeur effective de consigne (19) de la tension alternative de consigne (14) en fonction d'un courant fourni par le générateur de tension alternative (50).

9. Commande (10) pour une unité d'alimentation en énergie électrique (1) selon l'une quelconque des revendications 1 à 8, dans laquelle le détecteur de tension alternative de consigne (13) est en outre réalisé pour mettre à zéro la tension alternative de consigne (14) pendant au moins une période de tension alternative de consigne si une surtension se produit à l'intérieur du générateur de tension alternative (50).

10. Commande (10) pour une unité d'alimentation en énergie électrique (1) selon l'une quelconque des revendications 1 à 9, comprenant en outre :
a) une entrée de puissance de charge (21) à laquelle peut être transmise une puissance de charge (22) d'une charge connectée à l'unité d'alimentation en énergie électrique (1), et en particulier
b) une entrée de puissance de générateur (23) à laquelle peut être transmise une puissance de générateur (24) fournie par le générateur de tension alternative (50) de l'unité d'alimentation en énergie électrique (1),
dans laquelle le détecteur de tension alternative de consigne (13) est en outre réalisé pour détecter la valeur effective de consigne (19) de telle sorte que :
c) la puissance de générateur (24) est supérieure à la puissance de charge (22) si le premier niveau de remplissage (41) est supérieur au niveau de remplissage supplémentaire (141),
d) la puissance de générateur (24) est inférieure à la puissance de charge (22) si le premier niveau de remplissage (41) est inférieur au niveau de remplissage (141) supplémentaire,
e) la puissance de générateur (24) est égale à la puissance de charge (22) si le premier niveau de remplissage (41) correspond au niveau de remplissage supplémentaire (141).

11. Commande (10) pour une unité d'alimentation en énergie électrique (1) selon l'une quelconque des revendications 1 à 10, comprenant en outre :
a) une entrée de puissance d'échange (25) à laquelle peut être transmise une puissance d'échange (26) circulant de l'unité d'alimentation en énergie électrique (1) à l'unité d'alimentation en énergie électrique supplémentaire (101), et en particulier
b) un disjoncteur (27) réalisé pour établir une connexion électriquement conductrice entre l'unité d'alimentation en énergie électrique (1) et l'unité d'alimentation en énergie électrique supplémentaire (101) et pour couper la connexion électriquement conductrice, si :
i. la puissance d'échange (26) est inférieure à zéro et le premier niveau de remplissage (41) est égal ou inférieur à une première valeur seuil de niveau de remplissage prédéterminée (28),
ii. la puissance d'échange (26) est supérieure à zéro et le premier niveau de remplissage (41) est égal ou inférieur à une deuxième valeur seuil de niveau de remplissage prédéterminée (29).

12. Unité d'alimentation en énergie électrique (1), comprenant
a) une commande (10) selon l'une quelconque des revendications 1 à 11,
b) un premier accumulateur d'énergie (40) ;
c) un générateur de tension alternative (50) avec une première connexion (51) et une deuxième connexion (52), la première connexion (52) étant connectée de manière électriquement conductrice au premier accumulateur d'énergie (40), et le générateur de tension alternative (50) étant réalisé pour générer une tension alternative (54) correspondant à la tension alternative de consigne (14) au niveau de la deuxième connexion (52).

13. Unité d'alimentation en énergie électrique (1) selon la revendication 12, comprenant en outre un détecteur de niveau de remplissage (45) pour détecter un premier niveau de remplissage (41) du premier accumulateur d'énergie (40), et/ou une source d'énergie électrique (80) pouvant être connectée de manière électriquement conductrice au premier accumulateur d'énergie (40), et/ou un convertisseur de tension (90) connecté électriquement à la source d'énergie électrique (80) côté entrée et au premier accumulateur d'énergie (40) côté sortie, et/ou un chargeur (43) pouvant être connecté à un réseau d'alimentation électrique côté entrée et étant connecté au premier accumulateur d'énergie (40) côté sortie.

14. Système d'alimentation en énergie électrique (2), comprenant une unité d'alimentation en énergie électrique (1) selon l'une quelconque des revendications 12 et 13 et au moins une unité d'alimentation en énergie électrique supplémentaire (101), l'unité d'alimentation en énergie électrique (1) et l'unité d'alimentation en énergie électrique supplémentaire (101) étant connectées ensemble de manière électriquement conductrice, l'unité d'alimentation en énergie électrique supplémentaire (101) étant en particulier une unité d'alimentation en énergie électrique selon l'une quelconque des revendications 12 et 13.

15. Procédé de commande d'une unité d'alimentation en énergie électrique (1) selon l'une quelconque des revendications 12 et 13, comprenant les étapes consistant à :
a) détecter une tension alternative de consigne (14) en tenant compte d'un premier niveau de remplissage (41) d'un premier accumulateur d'énergie (40) de l'unité d'alimentation en énergie électrique (1) et/ou d'un niveau de remplissage supplémentaire (141) d'un accumulateur d'énergie supplémentaire (140) d'une unité d'alimentation en énergie électrique supplémentaire (101), dans lequel 1) une fréquence de consigne de la tension alternative de consigne est détectée en tenant compte du premier niveau de remplissage et/ou du niveau de remplissage supplémentaire, et/ou 2) le niveau de remplissage supplémentaire de l'accumulateur d'énergie supplémentaire est détecté à partir d'une fréquence supplémentaire d'une tension alternative supplémentaire d'un générateur de tension alternative supplémentaire de l'unité d'alimentation en énergie électrique supplémentaire,
b) transmettre la tension alternative de consigne (14) à un générateur de tension alternative (50) de l'unité d'alimentation en énergie électrique (1),
dans lequel la fréquence de consigne
e) correspond substantiellement à la fréquence supplémentaire si l'unité d'alimentation en énergie électrique supplémentaire est connectée de manière électriquement conductrice à l'unité d'alimentation en énergie électrique, et
f) sinon, est détectée en tenant compte du premier niveau de remplissage.
